# EUROPÄISCHE PATENTSCHRIFT

(11) **EP 2 992 547 B1**
(45) Veröffentlichungstag und Bekanntmachung des Hinweises auf die Patenterteilung: **22.04.2020**
(21) Anmeldenummer: 14721396.1
(22) Anmeldetag: 05.05.2014
(51) Int. Cl.: H01L 21/304, H01L 21/02

(54) **VERFAHREN UND VORRICHTUNG ZUR WAFERHERSTELLUNG MIT VORDEFINIERTER BRUCHAUSLÖSESTELLE**
METHOD AND DEVICE FOR PRODUCING WAFERS USING A PRE-DEFINED FRACTURE TRIGGER POINT
PROCÉDÉ ET DISPOSITIF DE FABRICATION DE PLAQUETTES PRÉSENTANT UNE ZONE DE DÉCLENCHEMENT DE RUPTURE PRÉDÉFINIE

(30) Priorität: 03.05.2013 DE 102013007672
(43) Veröffentlichungstag der Anmeldung: 09.03.2016
(60) Teilanmeldung: 18191428.4
(73) Patentinhaber: Siltectra GmbH, 01099 Dresden (DE)
(72) Erfinder: LICHTENSTEIGER, Lukas, 8400 Winterthur (CH); DRESCHER, Wolfram, 01099 Dresden (DE)
(74) Vertreter: Westphal, Mussgnug & Partner Patentanwälte mbB
(86) Internationale Anmeldenummer: PCT/EP2014/059120
(87) Internationale Veröffentlichungsnummer: WO 2014/177721

(56) Entgegenhaltungen:
- US-A1- 2010 310 775
- US-A1- 2013 082 357
- SAHA SAYAN ET AL: "Single heterojunction solar cells on exfoliated flexible PRG 25 m thick mono-crystalline silicon su", APPLIED PHYSICS LETTERS, AMERICAN INSTITUTE OF PHYSICS, US, Bd. 102, Nr. 16, 22. April 2013 (2013-04-22), Seiten 163904-163904, XP012172701, ISSN: 0003-6951, DOI: 10.1063/1.4803174 [gefunden am 2013-04-25]
- P.-O. BOUCHARD ET AL: "Analysis of stress intensity factors and T-stress to control crack propagation for kerf-less spalling of single crystal silicon foils", COMPUTATIONAL MATERIALS SCIENCE, Bd. 69, 1. März 2013 (2013-03-01), Seiten 243-250, XP055122724, ISSN: 0927-0256, DOI: 10.1016/j.commatsci.2012.10.033

## Beschreibung

Die vorliegende Erfindung bezieht sich auf ein Verfahren zur Herstellung von Festkörperschichten und auf eine Vorrichtung zum Herstellen von Festkörperschichten insbesondere Wafern.

In vielen technischen Bereichen (z.B. Mikroelektronik- oder Photovoltaiktechnologie) werden Materialien, wie z.B. Silizium, Germanium oder Saphir, häufig in der Form dünner Scheiben und Platten (so genannte Wafer) gebraucht. Standardmäßig werden solche Wafer derzeit durch Sägen aus einem Ingot hergestellt, wobei relativ große Materialverluste ("kerf-loss") entstehen. Da das verwendete Ausgangsmaterial oft sehr teuer ist, gibt es starke Bestrebungen, solche Wafers mit weniger Materialaufwand und damit effizienter und kostengünstiger herzustellen.

Beispielsweise gehen mit den derzeit üblichen Verfahren allein bei der Herstellung von Siliziumwafern für Solarzellen fast 50% des eingesetzten Materials als "kerf-loss" verloren. Weltweit gesehen entspricht dies einem jährlichen Verlust von über 2 Milliarden Euro. Da die Kosten des Wafers den größten Anteil an den Kosten der fertigen Solarzelle ausmachen (über 40%), könnten durch entsprechende Verbesserungen der Waferherstellung die Kosten von Solarzellen signifikant reduziert werden.

Besonders attraktiv für eine solche Waferherstellung ohne kerf-loss ("kerf-free wafering") erscheinen Verfahren, die auf das herkömmliche Sägen verzichten und z.B. durch Einsatz von temperaturinduzierten Spannungen direkt dünne Wafer von einem dickeren Werkstück abspalten können. Dazu gehören insbesondere Verfahren, wie sie z.B. in PCT/US2008/012140 und PCT/EP2009/067539 beschrieben sind, wo zum Erzeugen dieser Spannungen eine auf das Werkstück aufgetragene Polymerschicht verwendet wird. Die Schrift US 2013/082357 A1 (ALHOMOUDI IBRAHIM [US] ET AL) 4. April 2013 (2013-04-04) ist weiterer relevanter Stand der Technik.

Die Polymerschicht weist bei den erwähnten Verfahren einen im Vergleich zum Werkstück um ungefähr zwei Größenordnungen höheren thermischen Expansionskoeffizienten auf. Außerdem kann durch Ausnutzen eines Glasübergangs ein relativ hohes Elastizitätsmodul in der Polymerschicht erreicht werden, so dass im Schichtsystem Polymerschicht-Werkstück durch Abkühlen genügend große Spannungen induziert werden können, um die Abspaltung von Wafer vom Werkstück zu ermöglichen.

Beim Verfahren nach dem aktuellem Stand der Technik wird der Bruchvorgang, der zur Abspaltung des Wafers vom Werkstück führt, zufällig ausgelöst, wobei sowohl der genaue Zeitpunkt der Bruchauslösung wie auch der Ort nicht vorgegeben werden können. Häufig beginnt der Bruch an einer zufälligen Schwachstelle des Wafers, meist an der Kante bzw. am Rand, in einem Moment, wo die Spannung lokal einen kritischen Wert überschreitet. Infolge dieser Unbestimmtheit in Ort und Zeit der Bruchauslösung ist es schwierig, zu gewährleisten, dass zum Zeitpunkt der Bruchauslösung am Ort der Bruchauslösung ein für den Bruchvorgang optimales Spannungsfeld besteht. Dies kann zu einem ungünstigen Verlauf der Bruchfront und insbesondere zu signifikanten Dickenschwankungen des abgespaltenen Wafers führen. Oft verläuft der Bruch beispielsweise in mehreren Bruchfronten entlang verschiedener Richtungen, wobei es bei einem späteren Wiederaufeinandertreffen oder einer ungünstigen Überlagerung dieser Bruchfronten zu großen und oft abrupten Dickenschwankungen beim abgespaltenen Wafer kommen kann.

Es ist somit Aufgabe der vorliegenden Erfindung ein entsprechendes Verfahren und eine entsprechende Vorrichtung zur Herstellung von Festkörperschichten und/oder Festkörperplatten bereitzustellen, welches die Qualität der hergestellten Wafer gegenüber den bekannten Verfahren verbessert, insbesondere indem die Krümmung der abgespaltenen Festkörperschichten bzw. Wafer reduziert wird bzw. eine gleichmäßige Schichtdicke des Wafers erzeugt wird. Weitere Aufgaben der vorliegenden Erfindung sind die bei der Bruchpropagation entstehenden unerwünschten Oszillationen zu vermindern, den Wärmekontakt zum Schichtsystem zu verbessern und zudem die Möglichkeit einer einfacheren und schonenderen Handhabbarkeit der Festkörperschichten und/oder -platten nach dem Abspalten bereitzustellen.

Die zuvor genannte Aufgabe wird erfindungsgemäß durch ein Verfahren zur Herstellung von Festkörperschichten, insbesondere zur Verwendung als Wafer, gemäß dem Gegenstand von Anspruch 1 gelöst.

Die Idee der vorliegenden Erfindung ist es somit, eine oder mehrere definierte lokale Spannungsspitzen in das Schichtsystem einzubringen um die Bruchauslösung gezielt zu beeinflussen. Mittels räumlich lokaler Spannungsspitzen kann dadurch der Ort der Bruchauslösung gewählt werden, während mittels zeitlicher Spannungsspitzen (Spannungsimpulsen) der Zeitpunkt der Bruchauslösung kontrolliert werden kann.

Die vorliegende Erfindung stellt somit ein Verfahren zur Herstellung von Wafern bereit, welches die Qualität der hergestellten Wafer gegenüber den bisherigen Verfahren verbessert, indem Ort und/oder Zeit der Bruchauslösung besser kontrolliert werden können. Mit der vorliegenden Erfindung, d.h. mit der Verwendung von Schichtsystemen mit definierten lokalen Spannungsspitzen, werden somit die aus dem Stand der Technik bekannten Probleme behoben und dadurch die zuvor gestellte Aufgabe auf äußerst vorteilhafte Weise gelöst.

Die erfindungsgemäße Lösung beruht somit auf der Erkenntnis, dass bei den Verfahren nach bisherigem Stand der Technik das Abspalten eines Wafers jeweils am Rand des Wafers, und zwar meist an einer Ecke, beginnt. Diese Erkenntnis konnte mittels Videoaufzeichnungen mittels einer Hochgeschwindigkeitskamera erkannt werden. Der Wafer beginnt sich dann zu spalten, indem von dieser Stelle aus üblicherweise zwei Bruchfronten in jeweils entgegengesetzter Umlaufrichtung der Kante des Wafers entlanglaufen und schließlich ungefähr auf der gegenüberliegenden Seite des Wafers wieder aufeinander treffen. Erst danach spaltet sich das Zentrum des Wafers ab. Dieses Verhalten lässt sich dadurch erklären, dass die Kante des Wafers im Vergleich zum Inneren stets signifikant mehr Defekte im Material aufweist, was zu einer lokal verringerten Bruchfestigkeit führt, wodurch schließlich das Abspalten des Wafers entlang der Kante schon bei relativ geringeren Spannungen möglich ist.

Weitere vorteilhafte Ausgestaltungen der Erfindung sind Gegenstand der Unteransprüche.

Als Werkstück wird in den hier beschriebenen Anwendungsbeispielen vorzugsweise ein dickerer Wafer verwendet, von welchem dann unter Verwendung des beschriebenen erfindungsgemäßen Verfahrens ein oder mehrere, dünnere Wafer abgespaltet werden.

Gemäß einer weiteren bevorzugten Ausführungsform der vorliegenden Erfindung wird die vordefinierte lokale Spannungsinduzierung mittels einer Beaufschlagung des Werkstücks mit lokal eingeleiteten Kräften, einer lokalen Temperierung, insbesondere Abkühlung, einer lokalen Beaufschlagung mit Wellen, insbesondere Schallwellen oder Lichtwellen, einer lokalen Beaufschlagung mit Feldern, insbesondere elektromagnetischen Feldern, einer lokalen Beaufschlagung mit Elektrizität und/oder einer lokalen Beaufschlagung mit Strahlung aus einer Strahlungsquelle bewirkt.

Zusätzlich oder alternativ ist es auch möglich, durch gezieltes Erzeugen von Bereichen / Schichten unterschiedlicher Temperatur im Polymer entsprechend Bereiche / Schichten mit unterschiedlichem thermischen Expansionskoeffizienten und Elastizitätsmodul zu erzeugen. Auch andere physikalische Größen als die Temperatur können u.U. lokal den thermischen Expansionskoeffizienten einer entsprechenden Polymerschicht beeinflussen (z.B. Schwellen durch Lösungsmittel) und können dann zur gezielten Erzeugung von Bereichen / Schichten mit unterschiedlichem thermischen Expansionskoeffizienten verwendet werden.

Außerdem wird die mechanische Spannungsverteilung in der Schichtstruktur nicht nur durch den lokalen thermischen Ausdehnungskoeffizienten und das lokale Elastizitätsmodul bestimmt, sondern auch direkt durch die lokale Temperatur in der Schichtstruktur. Dadurch ist es auch möglich, durch Erzeugen einer gezielten Temperaturverteilung (z.B. unter Verwendung von individuell regelbaren Kühlzonen) in der Schichtstruktur eine gewünschte Spannungsverteilung zu erzeugen. Beispielsweise kann ein einzelnes, sehr kleines Gebiet innerhalb der Schichtstruktur im Randbereich des Wafers auf tiefere Temperaturen gekühlt werden als die restliche Schichtstruktur, was dazu führt, dass dort im Randbereich eine lokale Spannungsspitze erzeugt wird. Selbstverständlich sind auch andere Geometrien für solche Zonen unterschiedlicher Kühlung möglich und im Sinne der Erfindung. Das gezielte lokale Einbringen einer definierten Kühlleistung in das Schichtsystem wird außerdem erleichtert, wenn oberflächliche Strukturelemente aus einem thermisch gut leitenden sowie stabilen Material wie z.B. Metall bestehen.

Außerdem hat nicht nur die momentane Temperaturverteilung in der Schichtstruktur einen Einfluss auf die momentane Spannungsverteilung, sondern auch die zeitliche Änderung der Temperatur. Insbesondere hängen viele Materialeigenschaften des Polymers auch von der Kühlrate ab: Beispielsweise kann ein sehr schnelles Kühlen (mit Kühlraten über 10K/s) von bestimmten Bereichen lokale Spannungsspitzen in der Polymerschicht ermöglichen.

Insbesondere können zusätzliche externe Kräfte auch während des Kühlvorgangs vor dem Abspalten des Wafers gezielt auf definierte Bereiche des Schichtsystems ausgeübt werden, um definierte lokale Spannungsspitzen zu erzeugen. Beispielsweise kann eine nadelförmige Metallspitze im Bereich des Waferrandes gegen die Polymerfolie gepresst werden, um dort eine lokale Spannungsspitze im Schichtsystem zu erzeugen. Diese Ausführungsform ist vorteilhaft, da sie eine große Fülle unterschiedlicher Effekte zur Erzeugung einer Bruchauslösestelle bereitstellt.

Auf der Aufnahmeschicht ist gemäß einer weiteren bevorzugten Ausführungsform der vorliegenden Erfindung eine Stabilisierungsschicht angeordnet, wodurch eine Kompositstruktur gebildet wird und die lokale Spannungsinduzierung durch mindestens ein in der Kompositstruktur ausgebildetes Spannungsinduzierungsmittel bewirkt wird, welches eine Spannungsspitze in der abzuspaltenden Festkörperschicht derart erzeugt, dass sich die Bruchauslösestelle ausbildet. Diese Ausführungsform ist vorteilhaft, da das Spannungsinduziermittel räumlich und geometrisch vorgegeben gestaltbar, bereitstellbar und testbar ist, ohne dass ein Werkstück erforderlich ist. Weiterhin ist ein solches Spannungsinduziermittel besonders bevorzugt wiederverwendbar.

Für eine Erzeugung von thermisch induzierten Spannung wird der Wafer bevorzugt auf eine Temperatur vorgekühlt, bei der eine Spannung aufgebaut wird, welche unterhalb der Grenzspannung liegt. Das Material der Aufnahmeschicht bzw. das Polymer befindet sich vorteilhafterweise durch die Vorkühlung unterhalb seiner Glasübergangstemperatur. Mit Hilfe einer Beaufschlagungseinrichtung, insbesondere eines Lasers, wird durch einen zeitlich begrenzten Impuls Energie an eine bestimmte Stelle der Kompositstruktur, insbesondere des Wafer-Polymerverbundes, gebracht - vorzugsweise in einen örtlich begrenzten Teil der Waferkante. Zusätzlich oder alternativ können die thermischen Spannungen durch sehr starkes Licht und/oder einen (bevorzugt kleinen) Heizpunkt in der Halterung des Wafers, welcher sehr schnell sehr heiß gemacht werden kann, und/oder durch das Berühren des Wafers mit einem genügend heißen Gegenstand, wie z.B. einem heißen Stab und/oder durch ein heißes Fluid, insbesondere ein heißes Gas, erzeugt werden.

Alternativ ist denkbar, dass z.B. mit Hilfe von von kalten Gas, insbesondere mit Stickstoffdampf, bevorzugt erzeugt aus flüssigen Stickstoff, oder z.B. direkt mit flüssigem Stickstoff durch einen zeitlich begrenzten Dampfstrom oder Flüssigkeitsstrom Energie an eine bestimmte Stelle der Kompositstruktur, insbesondere des Wafer-Polymerverbundes, entzogen wird - vorzugsweise in einen örtlich begrenzten Teil der Waferkante. Kaltes Gas kann alternativ auch durch eine adiabatische Entspannung von Gasen erzeugt werden - die Temperatur muss präferiert deutlich unterhalb der Glasübergangstemperatur liegen (z.B. 100 K), wenigsten jedoch 5K und bevorzugt wenigstens 25K und besonders bevorzugt wenigstens 50K darunter.

Durch die lokale Erhitzung oder lokale Abkühlung entstehende thermische Spannungen wird die notwendige minimale Grenzspannung für das Aufreisen des Wafers überschritten (für Silizium ist der theoretische Wert 1,7 GPa, dieser wird z.B. durch Dotierungen und Gitterverunreinigungen sowie durch nicht ideale Kantenabschlüsse deutlich verringert) bzw. durch die thermisch induzierten Spannungen können Spannungserhöhungen aufgebaut werden. Dadurch wird unmittelbar der Riss ausgelöst und der Spaltvorgang beginnt. Typischerweise ist dieser nach weniger als 1 ms beendet. Damit sichert das Verfahren eine Definition des Zeitpunktes des Splittens, sobald genügend Spannung für die Rissinitialisierung aufgewendet bzw. erzeugt wird.

Zusätzlich oder alternativ ist die Ausnutzung des inversen Piezoeffekt möglich. Elastomere verfügen nämlich über piezoelektrische Eigenschaften, dadurch kann unter Ausnutzung des inversen Piezoeffektes folgender Aufbau gewählt werden.

Der Festkörper bzw. Wafer wird auf eine Temperatur vorgekühlt, bei der eine Spannung aufgebaut wird, welche unterhalb der Grenzspannung liegt. Das Polymer befindet sich vorteilhafterweise unterhalb der Glasübergangstemperatur. An einer Stelle des Wafer (präferiert am Rand) liegt eine Elektrode auf dem Polymer und eine zweite Elektrode beführt den Wafer. Durch Anlegen einer ausreichenden Spannung, kann das Polymer zur Kontraktion gebracht werden und damit die notwendige Grenzspannung überschritten werden. Wordurch ebenfalls unmittelbar der Riss ausgelöst wird und der Spaltvorgang beginnt. Typischerweise ist dieser ebenfalls nach weniger als 1 ms beendet. Damit sichert das Verfahren ebenfalls eine Definition des Zeitpunktes des Splittens, sobald genügend Spannung für die Rissinitialisierung aufgewendet wird.

Zusätzlich oder alternativ können mittels Schallwellen Spannungen erzeugt werden, die oberhalb der Grenzspannung liegen. Schallwellen können nämlich zur lokalen Energieeinbringung verwendet werden. Zur Ausnutzung von Schallwellen wird folgender Aufbau bevorzugt gewählt. Der Festkörper bzw. Wafer wird bevorzugt ebenfalls auf eine Temperatur vorgekühlt, bei der eine Spannung aufgebaut wird, welche unterhalb der Grenzspannung liegt. Das Polymer befindet sich ebenfalls vorteilhafterweise unterhalb der Glasübergangstemperatur. Schallwellen werden derart in den Festkörper und/oder die Aufnahmeschicht bzw. in die Kompositstruktur eingekoppelt, dass an einer Stelle genügend Energie eingebracht wird (vorzugsweise am Rand) um die notwendige Grenzspannung zu überschreiten, wodurch wiederum der Riss zeitlich definiert ausgelöst wird.

Eine zeitlich definierte Auslösung eines Risses in dem Festkörper hat insbesondere im industriellen Kontext, z.B. hinsichtlich der Prozesszeitsicherheit und dem Qualitätsmanagement, erhebliche Vorteile gegenüber den aus dem Stand der Technik bekannten Verfahren.

Das Spannungsinduzierungsmittel ist gemäß einer weiteren bevorzugten Ausführungsform eine lokale Unstetigkeit oder eine lokal eng begrenzte starke räumliche Änderung im E-Modul, dem thermischen Ausdehnungskoeffizienten, und/oder der Dicke der Stabilisierungsschicht und/oder der Aufnahmeschicht. Insbesondere entstehen solche Unstetigkeiten an den Rändern der Stabilisierungsschicht und/oder der Aufnahmeschicht und können durch Wahl von entsprechenden Randgeometrien gezielt beeinflusst werden.

Das Spannungsinduzierungsmittel ist gemäß einer weiteren bevorzugten Ausführungsform ein an der Stabilisierungsschicht und/oder der Aufnahmeschicht ausgebildeter Vorsprung, insbesondere mit einem spitzen Ende, oder eine darin ausgebildete Ausnehmung.

Es wurde diesbezüglich erkannt, dass der Grund für den Bruchbeginn in der Ecke darin liegt, dass sich lokale Spitzen im mechanischen Spannungsfeld befinden könnten, welche durch die eckige Geometrie des Schichtsystems hervorgerufen werden. Versuche, worin verschiedene Geometrien für das auf den Wafer aufgetragene Schichtsystem untersucht wurden, bestätigten dies. Die Brüche beginnen somit jeweils präferenziell in Bereichen des Schichtsystems mit scharfen Kanten und Ecken, und viel weniger in Gebieten mit großen Krümmungsradien.

In einem Ausführungsbeispiel werden Schichtbestandteile definierter Geometrie aus verschiedenen Materialien, die sich durch unterschiedliche thermische Expansionskoeffizienten auszeichnen, bei einer höheren Temperatur (z.B. zwischen Raumtemperatur und 150°C) miteinander zu einer Schichtstruktur fest verbunden (z.B. durch Verkleben oder Laminieren). Die Geometrie mindestens eines der Bestandteile der Schichtstruktur weist dabei mindestens einen Bereich mit spitzen Ecken oder Kanten (d.h., mit sehr kleinen lokalen Krümmungsradien) auf. Wird diese Schichtstruktur dann nach der Verfestigung abgekühlt, entstehen durch die unterschiedliche thermische Expansion in der Schichtstruktur Spannungsfelder, wobei in mindestens einem Bereich definierbare lokale Spannungsspitzen auftreten. Im Folgenden wird beschrieben, wie eine solche Schichtstruktur z.B. unter Verwendung von vorgefertigten Polymerfolien und Strukturelementen aus Metall von bestimmter Form hergestellt und zum Abspalten von Wafer verwendet werden kann.

Die Aufnahmeschicht wird bevorzugt durch mindestens ein Polymer gebildet, wobei das mindestens eine Polymer bzw. das sich aus mehreren Werkstoffen ergebende Polymer bevorzugt aus einem oder mehreren Duroplasten und/oder aus einem oder mehreren Elastomeren und/oder aus einem oder mehreren Thermoplasten und/oder aus einem oder mehreren thermoplastischen Elastomeren bestehen oder zumindest teilweise gebildet wird. Das Polymer weist somit bevorzugt mindestens einen Kunststoff, insbesondere mindestens ein Elastomer, insbesondere mindestens ein Silicon, insbesondere mindestens ein RTV-Silicon und/oder mindestens ein HTV-Silicon, insbesondere mindestens ein Polydimethylsiloxan (PDMS) auf oder besteht bevorzugt aus mindestens einem Kunststoff, insbesondere mindestens einem Elastomer, insbesondere mindestens einem Silicon, insbesondere mindestens einem RTV-Silicon und/oder mindestens einem HTV-Silicon, insbesondere mindestens ein Polydimethylsiloxan (PDMS).Als Polymer kann somit besonders bevorzugt z.B. ein Polydiorganolsiloxan verwendet werden, z.B. Polydimethylsiloxane (PDMS). Im Folgenden wird als Polymerschicht bzw. Aufnahmeschicht bevorzugt eine Folie aus PDMS verwendet.

Als Strukturelemente bzw. Stabilisierungsschicht/en werden bevorzugt Aluminiumplatten und als Werkstück bevorzugt ein dicker Wafer aus Silizium beschrieben; es können aber auch andere geeignete Polymere, Strukturelementmaterialien und Werkstücke (z.B. aus anderen Materialien wie Galliumarsenid, Germanium, Galliumnitrid, Siliziumcarbid, Saphir, etc.) verwendet werden.

Zur Herstellung der Polymerfolien wird bevorzugt PDMS verwendet. Dies ist ein zweikomponentiges Gemisch, das thermisch ausgehärtet wird (bevorzugte Mischverhältnisse zwischen Härter:Basismaterial liegen insbesondere bei Verhältnissen von 1:30 bis 1:3). Zum Härten werden - je nach Härtezeit - Temperaturen von der Raumtemperatur bis ca. 200°C, vorzugsweise von der Raumtemperatur bis ca. 120°C verwendet. Härtezeiten betragen bevorzugt zwischen ca. 1-120 Minuten (bei hohen Temperaturen) und 1-6 Tagen (bei Raumtemperatur). Bei PDMS handelt es sich vor dem Härten um eine viskose Flüssigkeit, die z.B. mittels Gießverfahren auf eine glatte Oberfläche (z.B. Spiegel) aufgebracht wird und dort zu einer Folie aushärtet. Die Folie wird von dieser Oberfläche dann abgezogen (z.B. mechanisch), gegebenenfalls weiterverarbeitet, und danach auf die zu beschichtende Oberfläche aufgebracht. Außerdem kann die fertige Folie bereits vor dem Aufbringen untersucht und ihre Qualität überprüft werden (z.B. mit üblichen mechanischen, optischen oder elektrischen Messverfahren, etc.). Neben dem hier beschriebenen Verfahren zur Folienherstellung sind viele andere Verfahren in der Industrie üblich (z.B. Herstellung durch Extrusion), welche ebenfalls für die vorliegende Erfindung anwendbar sind.

Auf eine so hergestellte erste Folie werden danach Strukturelemente bzw. eine Stabilisierungsschicht aus einem anderen Material aufgeklebt. Im Folgenden wird als Strukturelement eine Platte aus Aluminium beschrieben, es können aber auch Strukturelemente aus anderen geeigneten Materialien (z.B. Messing, Stahl, Silizium, Glas etc.) verwendet werden. Bevorzugt unterscheiden sich die thermischen Expansionskoeffizienten der Folie und der Strukturelemente stark (mindestens um einen Faktor 2 bis 5). Aluminium beispielsweise besitzt einen um ungefähr ein bis zwei Größenordnungen kleineren thermischen Expansionskoeffizienten als PDMS. Die Strukturelemente und/oder bestimmte Bereiche der PDMS-Folie sind dabei in einer vordefinierten Form gefertigt, d.h. insbesondere mit mindestens einer scharfen Ecke, Vorsprung oder Kante, um die gewünschten lokalen Spannungsspitzen zu erzeugen. Im beschriebenen Ausführungsbeispiel wird z.B. eine Metallplatte verwendet, deren Fläche und Form etwa derjenigen des Wafers entspricht, mit dem Unterschied, dass ihr Rand an einer Stelle zu einer spitzen Ecke ausläuft und sonst überall abgerundet ist.

Wichtig ist auch eine gute Haftung zwischen der Aufnahmeschicht bzw. der Folie und der Stabilisierungsschicht bzw. den Strukturelementen, da die Verbindung zwischen Strukturelement/en und Folie genügend große Scherkräfte für das Abspalten sowie große Temperaturschwankungen für das thermische Induzieren der nötigen Spannungen aushalten können muss. Die Haftung kann verbessert werden z.B. durch mechanisches Aufrauen der Metalloberfläche, Eloxieren des Aluminiums, Ätzprozesse, etc.

Für das Aufkleben der Folie bietet sich z.B. ein Polymerfilm, insbesondere ein dünner PDMS-Film, als Kleber an. Das PDMS wird dabei bevorzugt im flüssigen Zustand vorzugsweise auf beide zu verklebenden Oberflächen dünn aufgetragen (einige Milliliter für einen 6-inch Wafer). Danach wird die Folie auf die Metallplatte aufgelegt und mit einer Rolle oder Walze unter leichtem Druck angepresst. Durch Hin- und Herbewegen der Rolle verteilt sich der Kleberfilm unter der Folie, Luftblasen werden entfernt. Die Aushärtung des Klebers kann bei Temperaturen zwischen Raumtemperatur und ca. 200°C erfolgen. Die Härtezeiten variieren, wie bei der Folienherstellung, in Abhängigkeit von der Härtetemperatur (siehe oben). Alternativ zum beschriebenen Verfahren kann die Folie auch mit anderen üblichen Verfahren auf die Metallplatte aufgeklebt werden, z.B. unter Verwendung eines Vakuum-Laminators. Ferner kann die Folie auch direkt (ohne Kleber) mit der Oberfläche der Metallplatte verbunden werden, z.B. mittels "Plasma activated bonding" (z.B. Aktivierung der PDMS-Folie in Stickstoffplasma, Aufpressen der Folie auf Metallplatte, ggf. "Annealing") oder z.B. durch Auflaminieren (Aufschmelzen) einer thermoplastischen Folie (z.B. Geniomer von Wacker Silicones).

Nach dem Aufkleben der Aufnahmeschicht bzw. der ersten Polymerfolie auf die Stabilisierungsschicht bzw. Metallplatte und nach dem Aushärten des Klebers wird mit einem analogen Verfahren das Werkstück (im vorliegenden Beispiel ein dicker Siliziumwafer) auf die erste Polymerfolie geklebt, und danach wird bevorzugt - insbesondere mit einem analogen Verfahren - eine zweite, im Allgemeinen dickere Polymerfolie, auf die noch freie Seite des Wafers geklebt. Zum Schluss werden im vorliegenden Beispiel die seitlichen Ränder aller Polymerfolien getrimmt, so dass sie die gewünschte Randgeometrie haben.

Im Rahmen einer Prozessalternative ist es bevorzugt auch möglich, eine oder beide der verwendeten Polymerschichten nicht als vorgefertigte Folie aufzukleben, sondern direkt in situ herzustellen. Beispielsweise können sowohl Strukturelemente wie auch Wafer mit Hilfe einer Schalungsvorrichtung direkt mit flüssigem PDMS zu einer Kompositstruktur vergossen werden.

Unabhängig vom jeweiligen Ausführungsbeispiel gilt: Die benötigten Dicken und Materialeigenschaften (insbesondere thermische Expansionskoeffizienten und Elastizitätsmodule) der verwendeten Polymerschichten sowie der Metallplatte bzw. Strukturelemente hängen von den Dicken und Materialeigenschaften des Werkstücks sowie der gewünschten Zieldicke des abzuspaltenden Wafers ab. Bei den beschriebenen Anwendungsbeispielen wird bevorzugt ein 400 Mikrometer dicker, monokristalliner, pseudoquadratischer 6-inch Siliziumwafer mit <100> Orientierung hälftig in zwei 200 Mikrometer dicke Wafer gespalten. Dazu werden besonders bevorzugt die folgenden Dicken verwendet: Die Stabilisierungsschicht bzw. Metallplatte, insbesondere bestehend aus Aluminium und zwischen 0.5 und 5 Millimeter dick, die Aufnahmeschicht bzw. die erste Polymerschicht (zwischen Metallplatte und Werkstück), insbesondere zwischen 0.2 und 5 Millimeter dick, die zweite Polymerschicht, insbesondere zwischen 0.2 und 10 Millimeter dick. Die seitlichen Abmessungen der Polymerschichten entsprechen jeweils denen des Wafers, wobei in diesem Ausführungsbeispiel die Ränder bündig mit dem Waferrand übereinander liegen. Die seitlichen Abmessungen der Metallplatte entsprechen, wie erwähnt, bevorzugt auch denen des Wafers, außer dass bevorzugt mindestens eine oder genau eine Stelle des Randes in eine Spitze Ecke der Metallplatte ausläuft und die restlichen Randbereiche abgerundet sind.

Nachdem das Schichtsystem Metallplatte-mit-Strukturelementen-Polymerschicht-Werkstück-Polymerschicht z.B. unter Verwendung eines der vorher beschriebenen Ausführungsbeispiele hergestellt und das Polymer ausgehärtet ist, wird wie in den bzgl. des Stands der Technik beschriebenen Patentanmeldungen des Anmelders üblich z.B. durch thermisch induzierte Spannungen ein dünner Wafer vom Werkstück abgelöst, wobei ein Teil der Schichtstruktur (in den beschriebenen Beispielen die zweite Polymerschicht) noch auf einer Seite des Wafers anhaftet. Diese Schichtstruktur kann dann vom hergestellten Wafer z.B. mit mechanischen oder chemischen Methoden abgelöst werden, wie in den erwähnten Referenzen dargestellt. Am verbleibenden Rest des Werkstücks haftet entsprechend auf einer Seite noch der andere Teil der Schichtstruktur mit den Strukturelementen (in den beschriebenen Beispielen die erste Polymerschicht und daran die Metallplatte). Auch dieser kann z.B. mit mechanischen oder chemischen Methoden abgelöst werden, wie in den erwähnten Referenzen bzw. Patentanmeldungen des Anmelders dargestellt.

Nachdem die Schichtstruktur (mit oder ohne verbundene Strukturelemente) vom hergestellten Wafer abgelöst ist, kann sie - falls gewünscht - gereinigt und danach auf ein neues Werkstück aufgebracht werden. Dadurch ist es möglich, dieselbe Schichtstruktur (mit oder ohne verbundene Strukturelemente) mehrfach zur Herstellung von Wafer zu verwenden. Dies kann den Materialverbrauch und die Kosten des Gesamtprozesses signifikant reduzieren. Für eine Wiederverwendung der Schichtstruktur ist es insbesondere vorteilhaft, zur Befestigung des Werkstücks einen wieder auflösbaren Kleber zu verwenden, da in diesem Fall nach dem Auflösen der Kleberschicht an der Schichtstruktur keine Kleberrückstände mehr verbleiben.

In den beschriebenen Ausführungsbeispielen wird dargestellt, wie mechanische Spannungsspitzen in Schichtstrukturen bestehend aus Polymerschichten und Strukturelementen aus anderen Materialien (insbesondere Materialien mit wesentlich kleineren thermischen Expansionskoeffizienten als die verwendeten Polymere, also insbesondere Metalle) zur Lösung der eingangs erwähnten Probleme bei der Herstellung von Wafer verwendet werden können. Um entsprechende Schichtstrukturen bestehend aus Komponenten mit jeweils unterschiedlichen thermischen Expansionskoeffizienten zu erzeugen, müssen aber nicht unbedingt unterschiedliche Materialien kombiniert werden: Es ist z.B. auch möglich, durch unterschiedliche Bearbeitung des verwendeten Polymers (insbesondere unterschiedliche Härtung) Polymerschichten mit unterschiedlichen thermischen Expansionskoeffizienten herzustellen. Außerdem hängt der thermische Expansionskoeffizient sowie das Elastizitätsmodul des verwendeten Polymers stark von der Temperatur ab (mit einem ausgeprägten Glasübergang bei ca. -125°C, wo z.B. das Elastizitätsmodul um mehrere Größenordnungen ansteigt, während sich der thermische Expansionskoeffizient um ungefähr, im Wesentlichen oder genau einen Faktor 4 verringert).

In zusätzlichen oder alternativen Ausführungsbeispielen werden direkt bei der Herstellung Spannungsverteilungen mit definierten lokalen Spannungsspitzen in die Schichtstruktur mit eingebaut. Dies kann beispielsweise wie folgt erreicht werden: Bevor z.B. eine Polymerschicht (z.B. eine vorgefertigte Polymerfolie) mit einer anderen Schicht verbunden (z.B. aufgeklebt) wird, wird ein definierter Bereich dieser Polymerschicht mit einer definierten mechanischen Vorspannung, insbesondere mit einer lokalen Spannungsspitze, beaufschlagt. Dies kann z.B. geschehen, indem ein Bereich der Polymerfolie vor dem Aufkleben durch definierte äußere Kräfte in eine oder mehrere Richtungen unter Zugspannung gesetzt wird, beispielsweise durch externes mechanisches Ziehen an den Folienrändern oder durch externes mechanisches Krümmen der Folie. Nach dem Aushärten des Klebers werden die äußeren Kräfte ausgeschaltet, aber der Schichtverbund verbleibt unter Spannung. Außerdem können äußere Kräfte auch zum Vorspannen von beliebigen anderen Komponenten des Schichtsystems verwendet werden: so können z.B. zur Erzeugung von lokalen Spannungsspitzen anstelle oder zusätzlich zur Polymerschicht auch Bereiche des Wafers durch externe Kräfte vor dem Verkleben unter Zugspannung gesetzt oder gekrümmt werden.

Gemäß einer weiteren bevorzugten Ausführungsform der vorliegenden Erfindung erstreckt sich das Spannungsinduzierungsmittel mit seiner Längsachse in der Längsrichtung und/oder in der Tiefenrichtung der Stabilisierungsschicht. Diese Ausführungsform ist vorteilhaft, da das Spannungsinduzierungsmittel durch die jeweilige Ausrichtung seiner Längsachse beliebig zur definierten Spannungsinduzierung einsetzbar ist.

In Umfangsrichtung der Stabilisierungsschicht bzw. der Metallplatte sind gemäß einer weiteren bevorzugten Ausführungsform der vorliegenden Erfindung mehrere Spannungsinduzierungsmittel an der Stabilisierungsschicht ausgebildet. Diese Ausführungsform ist vorteilhaft, da zeitgleich oder zeitversetzt an mehreren Stellen des Waferrands Bruchauslösestellen erzeugbar sind.

Das Spannungsinduzierungsmittel ist gemäß einer weiteren bevorzugten Ausführungsform der vorliegenden Erfindung ein an der Aufnahmeschicht bzw. der Polymerschicht ausgebildeter Vorsprung oder eine darin ausgebildete Ausnehmung. Diese Ausführungsform ist vorteilhaft, da die Polymerschicht bevorzugt unmittelbar an dem Werkstück anliegt und somit durch die Geometrie der Polymerschicht bewirkte Spannungen im Werkstück unmittelbar erzeugt werden.

Die lokale Spannungsinduzierung wird gemäß einer weiteren bevorzugten Ausführungsform der vorliegenden Erfindung mittels einer Impulsaussendeeinrichtung bewirkt, wobei die Impulsaussendeeinrichtung Wellen, insbesondere Schallwellen oder Lichtwellen, aussendet. Diese Ausführungsform ist vorteilhaft, da die Impulsstärke, Impulshäufigkeit, Impulsdauer und/oder Impulsrichtung bevorzugt einstellbar ist.

Mehrere Impulsaussendeeinrichtungen sind gemäß einer weiteren bevorzugten Ausführungsform der vorliegenden Erfindung in Umfangsrichtung des Werkstücks angeordnet und an mehreren in Umfangsrichtung des Werkstücks vorgesehenen Stellen werden mittels der Impulsaussendeeinrichtungen Spannungen induziert. Diese Ausführungsform ist vorteilhaft, da beliebig viele Bruchauslösestellen zeitgleich oder zeitversetzt erzeugbar sind.

Die lokale Spannungsinduzierung wird gemäß einer weiteren bevorzugten Ausführungsform der vorliegenden Erfindung mittels eines Spannungsinduzierungsmittels und einer Impulsaussendeeinrichtung bewirkt, wobei das Spannungsinduzierungsmittel durch eine geometrische Ausgestaltung der Kompositstruktur gebildet wird und die Impulsaussendeeinrichtung Wellen, insbesondere Lichtwellen oder Schallwellen, aussendet. Diese Ausführungsform ist vorteilhaft, da in dem Werkstück eine erste Spannung z.B. mittels des Spannungsinduziermittels erzeugt werden kann und eine zweite bzw. zusätzliche Spannung bzw. Spannungserhöhung durch die Impulsaussendeeinrichtung bewirkt werden kann. Die durch die Impulsaussendeeinrichtung ausgesendeten Impulse können somit bevorzugt als Bruchauslöseimpulse verstanden werden und die durch das bzw. die Spannungsinduziermittel induzierten Spannungen können bevorzugt als Grundspannungen verstanden werden.

Die lokale Spannungsinduzierung durch das Spannungsinduzierungsmittel und die Impulsaussendeeinrichtung gemäß einer weiteren bevorzugten Ausführungsform der vorliegenden Erfindung erfolgen zumindest zeitweise und bevorzugt stets zeitgleich oder zeitweise zeitversetzt.

Das zeitliche Zusammenspiel der externen Kräfte mit dem Ablauf des Kühlvorgangs ist ferner zu berücksichtigen, da auch dies von hoher Bedeutung ist: Da wesentliche Materialeigenschaften wie z.B. Elastizitätsmodule der Polymerschichten oberhalb der Glasübergangstemperatur wesentlich andere Werte annehmen als unterhalb der Glasübergangstemperatur, ist es für die Spannungsverteilung wichtig, ob externe Kräfte nur oberhalb oder nur unterhalb des Glasübergangs oder bei allen Temperaturen ausgeübt werden. Außerdem können Materialeigenschaften, wie Elastizitätsmodule, insbesondere im Polymer, auch durch das Ausüben von externen Kräften beeinflusst werden (z.B. können sich die Molekülketten des Polymers entlang der externen Kräfte ausrichten, so dass das Polymer anisotrop wird).

Spannungsspitzen können nicht nur räumlich, sondern auch zeitlich definiert werden. Beispielsweise können externe Kräfte als zeitlich eng begrenzter Impuls auf das Schichtsystem ausgeübt werden, beispielsweise auch als Schallimpuls. Oder beispielsweise kann ein bestimmter Bereich des Schichtsystems zeitlich sehr schnell (schockartig) gekühlt werden. Weiterhin ist denkbar, dass Spannungsspitzen räumlich und zeitlich kombiniert definiert werden. Diese Ausführungsform ist vorteilhaft, da sich dadurch der Zeitpunkt der Bruchauslösung beeinflussen bzw. kontrollieren lässt.

Gemäß einer weiteren bevorzugten Ausführungsform der vorliegenden Erfindung wird die lokale Spannungsinduzierung durch das Spannungsinduzierungsmittel zeitlich länger bewirkt als durch die Impulsaussendeeinrichtung, wobei die Impulsaussendeeinrichtung insbesondere in Abhängigkeit der Spannungsinduzierungsmittel gesteuert wird. Diese Ausführungsform ist vorteilhaft, da die durch die unterschiedlichen Einrichtungen/Mittel induzierten Spannungen dadurch optimal aufeinander abgestimmt werden können.

Ferner wird gemäß einer weiteren bevorzugten Ausführungsform der vorliegenden Erfindung eine vordefinierte Spannungsverteilung innerhalb des Werkstücks zum Beeinflussen, insbesondere zum definierten Vorgeben, eines Abspaltverlaufs beim Abspalten der Festkörperschicht von dem Werkstück induziert und die Festkörperschicht wird von dem Werkstück entlang einer sich innerhalb des Werkstücks erstreckenden Ebene gemäß dem durch die vordefinierte Spannungsverteilung beeinflussten Abspaltverlauf abgespalten. Diese Ausführungsform ist vorteilhaft, da durch die gesteuerte bzw. manipulierte bzw. beeinflusste Rissausbreitung vorteilhafte Effekte hinsichtlich der Dicke der Festkörperschicht bewirkbar sind.

Die vordefinierte Spannungsverteilung stellt gemäß einer weiteren bevorzugten Ausführungsform der vorliegenden Erfindung eine Spannungsverteilung dar, gemäß der die Spannungsintensität innerhalb einer Ebene des Werkstücks ausgehend vom Zentrum des Werkstücks in Richtung der Randbereiche des Werkstücks zumindest abschnittsweise verschieden ist, wobei die Spannungsintensität im Zentrum des Werkstücks bevorzugt größer ist als in der Nähe der Randbereiche des Werkstücks. Diese Ausführungsform ist vorteilhaft, da sie ebenfalls die Rissausbreitung positiv beeinflusst, wodurch sehr homogene Festkörperschichten erzeugbar sind.

Gemäß einer weiteren bevorzugten Ausführungsform der vorliegenden Erfindung weist die Aufnahmeschicht bevorzugt ein Polymer auf bzw. besteht zumindest teilweise und besonders bevorzugt vollständig aus einem Polymer, wobei beim Beaufschlagen der Kompositstruktur, die bevorzugt zumindest aus der Aufnahmeschicht und dem Werkstück besteht, mit einem inneren und/oder äußeren Spannungsfeld mindestens ein Teil und bevorzugt mehrere Teile des Polymers, insbesondere PDMS, durch genau einen Glasübergang, mindestens einen Glasübergang oder mehrere, insbesondere zeitliche versetzte, Glasübergänge gehen. Es ist hierbei denkbar, dass das Initiieren des Glasübergangs infolge z.B. mechanischer und/oder chemischer und/oder thermischer und/oder akustischer Effekte bzw. Beaufschlagungen bewirkt wird.

Gemäß einer weiteren bevorzugten Ausführungsform der vorliegenden Erfindung werden durch eine Temperierung der Aufnahmeschicht Grundspannungen in dem Werkstück erzeugt, wobei die Grundspannungen geringer sind als die zur Rissauslösung erforderlichen Spannungen und durch die vordefinierte lokale Spannungsinduzierung im Randbereich wird eine zusätzliche lokale Spannungserhöhung bewirkt, durch welche der Bruch ausgelöst wird, wobei ein Zeitraum zwischen der Erzeugung der Grundspannungen und der lokalen Spannungsinduzierung definiert vorgegeben oder eingestellt wird. Diese Lösung ist vorteilhaft, da die Intensität der Grundspannungen sehr genau unterhalb der für die Rissauslösung erforderlichen Spannungsintensität einstellbar ist und nach dem Einstellen der Grundspannungen bevorzugt zu einem beliebigen Zeitpunkt die Rissauslösung mittels eines weiteren Impulses, insbesondere einer lokalen Beaufschlagung des Werkstücks im Randbereich, ein Riss bzw. Bruch ausgelöst werden kann. Da die Intensität der Rissauslösespannungen bevorzugt größer ist als die Intensität der Rissführungsspannungen müssen durch diese Lösung z.B. keine vollflächig induzierten Spannungen im Bereich der Rissauslösespannungen erzeugt werden, wodurch eine deutlich präzisere Rissführung ermöglicht wird, da insgesamt deutlich weniger Energie in das Werkstück eingebracht wird.

Weiterhin ergibt sich durch den bevorzugt zeitlichen Versatz der Grundspannungserzeugung und der lokalen Spannungsinduzierung, dass zunächst die Grundspannungen definiert erzeugt werden können und zu einem bevorzugt nachgelagerten Zeitpunkt lokal die zusätzlichen zur Rissauslösung erforderlichen Spannungen erzeugt werden. Beispielsweise werden die Grundspannungen durch die Temperierung, insbesondere Abkühlung der Aufnahmeschicht, erzeugt und ein, zwei, drei oder mehrere Sekunden später, wobei auch Bruchteile davon denkbar sind (wie z.B. 0,1 Sek., oder 1,25 Sek., oder 0,001 Sek), wird mittels einer Beaufschlagung der Kompositstruktur, insbesondere des Werkstücks, mit lokal eingeleiteten Kräften, einer lokalen Temperierung, insbesondere Abkühlung oder Aufheizung, einer lokalen Beaufschlagung mit Wellen, insbesondere Schallwellen oder Lichtwellen, einer lokalen Beaufschlagung mit Feldern, insbesondere elektromagnetischen Feldern, einer lokalen Beaufschlagung mit Elektrizität, insbesondere unter Ausnutzung des inversen Piezoeffekts, und/oder einer lokalen Beaufschlagung mit Strahlung aus einer Strahlungsquelle die Erzeugung der lokalen Spannungen bewirkt, durch welche der Riss bzw. Bruch ausgelöst wird.

Die vorliegende Erfindung ist ebenfalls auf eine Vorrichtung zur Herstellung von Festkörperschichten, insbesondere Wafern, gerichtet. Die erfindungsgemäße Vorrichtung umfasst mindestens eine Einrichtung zum Induzieren von definierten lokalen Spannungen in einen Randbereich eines Werkstücks zum Erzeugen einer Bruchauslösestelle in dem Werkstück zum Abspalten einer Festkörperschicht von dem Werkstück, wobei die Einrichtung einen Grundkörper aufweist, der eine im Wesentlichen ebene Oberfläche zum Aufnehmen der Festkörperschicht aufweist und wobei ein Spannungsinduzierungsmittel an dem Grundkörper ausgebildet ist und sich mit seiner Längsachse in der Längsrichtung des Grundkörpers oder in der Tiefenrichtung des Grundkörpers erstreckt.

Die vorliegende Erfindung kann sich ferner auf einen Wafer beziehen, der nach dem erfindungsgemäßen Verfahren oder mit der erfindungsgemäßen Vorrichtung hergestellt wird.

Weiterhin werden die Gegenstände der Druckschriften PCT/US2008/012140 und PCT/EP2009/067539 vollumfänglich durch Bezugnahme zum Gegenstand der vorliegenden Patentanmeldung gemacht. Ebenso werden die Gegenstände zweier am Anmeldetag der vorliegenden Patentanmeldung von der Anmelderin ebenfalls eingereichten und das Gebiet der Herstellung von Festkörperschichten betreffenden weiteren Patentanmeldungen vollumfänglich zum Gegenstand der vorliegenden Patentanmeldung gemacht.

Die Verwendung der Wörter "im Wesentlichen" definiert bevorzugt in allen Fällen, in denen diese Wörter im Rahmen der vorliegenden Erfindung verwendet werden eine Abweichung im Bereich von 1%-30%, insbesondere von 1%-20%, insbesondere von 1%-10%, insbesondere von 1%-5%, insbesondere von 1%-2%, von der Festlegung, die ohne die Verwendung dieser Wörter gegeben wäre.

Weitere Vorteile, Ziele und Eigenschaften der vorliegenden Erfindung werden anhand nachfolgender Beschreibung der beigefügten Zeichnungen erläutert, in welchen beispielhaft erfindungsgemäße Wafer, Trägereinheiten und Vorrichtungen dargestellt sind. Bauteile oder Elemente der erfindungsgemäßen Wafer, Trägereinheiten und Vorrichtungen, welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Einzelne oder alle Darstellungen der im Nachfolgenden beschriebenen Figuren sind bevorzugt als Konstruktionszeichnungen anzusehen, d.h. die sich aus der bzw. den Figuren ergebenden Abmessungen, Proportionen, Funktionszusammenhänge und/oder Anordnungen entsprechen bevorzugt genau oder bevorzugt im Wesentlichen denen der erfindungsgemäßen Vorrichtung bzw. des erfindungsgemäßen Produkts.

Es zeigt:
- Fig. 1a: eine erste schematische Darstellung einer Schichtanordnung gemäß dem Gegenstand der vorliegenden Erfindung;
- Fig. 1b: eine zweite schematische Darstellung einer Schichtanordnung gemäß dem Gegenstand der vorliegenden Erfindung;
- Fig. 1c: eine dritte schematische Darstellung einer Schichtanordnung gemäß dem Gegenstand der vorliegenden Erfindung;
- Fig. 1d: eine erste schematische Darstellung der Erzeugung einer Aufnahmeschicht auf einer Stabilisierungsschicht;
- Fig. 1e: eine zweite schematische Darstellung der Erzeugung einer Aufnahmeschicht auf einer Stabilisierungsschicht;
- Fig. 2a: ein erster definierter Spannungsverlauf innerhalb einer ersten bevorzugten Grundform eines Werkstücks;
- Fig. 2b: ein zweiter definierter Spannungsverlauf innerhalb der ersten bevorzugten Grundform eines Werkstücks;
- Fig. 2c: ein dritter definierter Spannungsverlauf innerhalb der ersten bevorzugten Grundform eines Werkstücks;
- Fig. 2d: ein vierter definierter Spannungsverlauf innerhalb der ersten bevorzugten Grundform eines Werkstücks;
- Fig. 2e: ein fünfter definierter Spannungsverlauf innerhalb der ersten bevorzugten Grundform eines Werkstücks;
- Fig. 2f: ein sechster definierter Spannungsverlauf innerhalb der ersten bevorzugten Grundform eines Werkstücks;
- Fig. 3a: ein weiterer definierter Spannungsverlauf in einer zweiten bevorzugten Grundform des Werkstücks;
- Fig. 3b: noch einen weiteren definierten Spannungsverlauf in der zweiten bevorzugten Grundform des Werkstücks;
- Fig. 3c: noch einen weiteren definierten Spannungsverlauf in der zweiten bevorzugten Grundform des Werkstücks;
- Fig. 3d: noch einen weiteren definierten Spannungsverlauf in der zweiten bevorzugten Grundform des Werkstücks;
- Fig. 3e: noch einen weiteren definierten Spannungsverlauf in der zweiten bevorzugten Grundform des Werkstücks;
- Fig. 4: eine schematische Darstellung eines bevorzugten Ablaufs des erfindungsgemäßen Herstellungsverfahrens;
- Fig. 5a: die Aufbringung von Spannungen auf einem Werkstück mittels einer Impulsaussendungseinrichtung;
- Fig. 5b: eine Stabilisierungsschicht die zwei verschiedene Spannungsinduzierungsmittel aufweist;
- Fig. 5c: eine vergrößerte Darstellung des in Fig. 5b gekennzeichneten Bereichs B;
- Fig. 5d: eine Seitenansicht des in Fig. 5c in der Draufsicht gezeigten Bereichs B;
- Fig. 6a: eine Draufsicht verschiedener Spannungszustände im Werkstück;
- Fig. 6b: weitere Draufsicht verschiedener Spannungszustände im Werkstück;
- Fig. 7a: eine weitere Ausführungsform einer Stabilisierungsschicht;
- Fig. 7b: weitere Spannungszustände in dem Werkstück;
- Fig. 8a: noch eine weitere Ausführungsform einer Stabilisierungsschicht;
- Fig. 8b: weitere Spannungszustände in dem Werkstück;
- Fig. 9a: eine schematische Draufsicht auf eine Mehrschichtstruktur, welche eine Aufnahmeschicht, eine Stabilisierungsschicht und das Werkstück umfasst;
- Fig. 9b: eine Seitenansicht der Mehrschichtstruktur aus Fig. 9a entlang des in Fig. 9a dargestellten Schnitts S;
- Fig. 9c: eine vergrößerte Darstellung des in Fig. 9b kreisförmig markierten Bereichs,
- Fig. 10: eine schematische Darstellung einer Ausführungsform, gemäß der das Spannungsinduzierungsmittel abschnittsweise die Außenseite des Werkstücks überlagert;
- Fig. 11a: eine schematische Darstellung einer Ausführungsform, gemäß der das Spannungsinduzierungsmittel als Ausnehmung in der Aufnahmeschicht ausgebildet ist; und

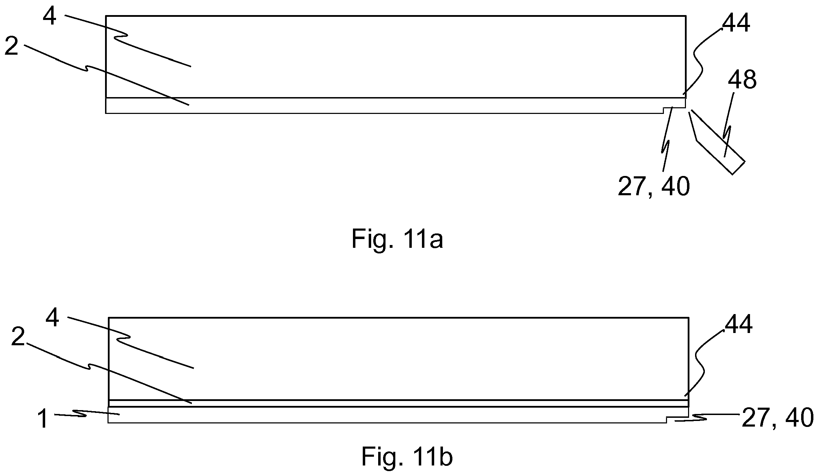

- Fig. 11 b: eine schematische Darstellung einer Ausführungsform, gemäß der das Spannungsinduzierungsmittel als Ausnehmung in der Stabilisierungsschicht ausgebildet ist.

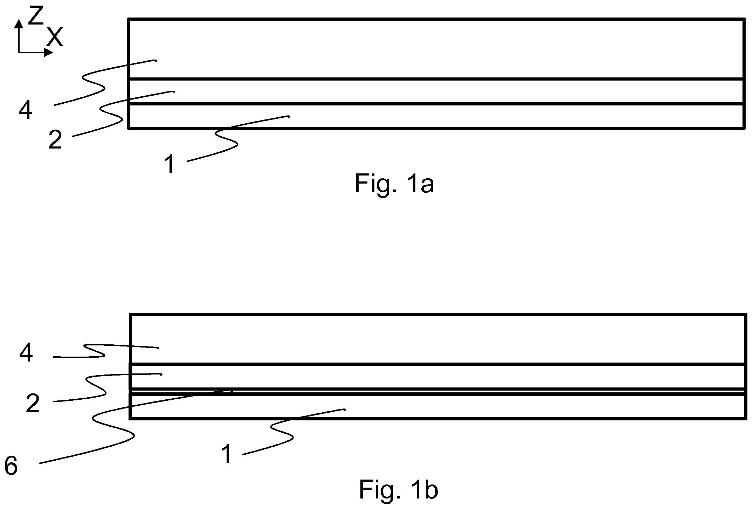

In Fig. 1a ist eine erste schematische Querschnittsdarstellung des erfindungsgemäßen Schichtaufbaus dargestellt. Der Schichtaufbau weist gemäß dieser Darstellung zumindest eine Stabilisierungsschicht 1, eine darüber bzw. daran bzw. darauf angeordnete Aufnahmeschicht 2 und ein darüber bzw. daran bzw. darauf angeordnetes Werkstück 4, insbesondere eine dicke Siliziumscheibe, auf.

Die einzelnen Schichten 1, 2, 4 können sich dabei in X, Y und Z Richtung gleich weit erstrecken, wobei auch denkbar ist, dass sich nur einzelne dieser Schichten in eine oder mehrere Richtungen gleich weit erstrecken. Bevorzugt erstrecken sich die einzelnen Schichten 1, 2, 4 zumindest in Z-Richtung jeweils unterschiedlich weit.

In Fig. 1b ist der in Fig. 1a gezeigte Schichtaufbau durch eine Klebeschicht 6, die zwischen der Stabilisierungsschicht 1 und der Aufnahmeschicht 2 ausgebildet ist, ergänzt. Die Klebeschicht 6 kann dazu verwendet werden die Stabilisierungsschicht 1 mit der Aufnahmeschicht 2 zu verbinden. Es sind jedoch Ausführungsformen denkbar, in denen auf eine Klebeschicht 6 verzichtet werden kann.

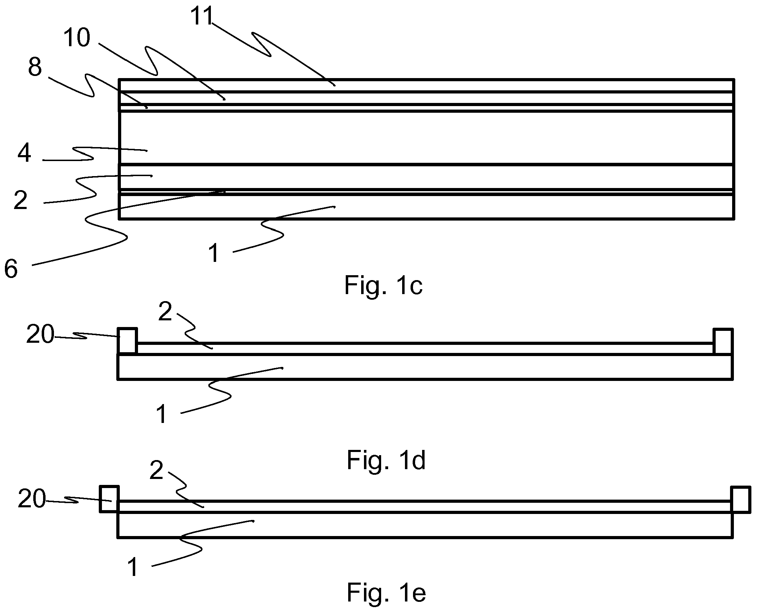

In Fig. 1c ist der in Fig. 1b gezeigte Schichtaufbau durch eine Verbindungsschicht 8, eine weitere Aufnahmeschicht 10 und eine weitere Schicht 11 ergänzt. Die Verbindungsschicht 8 wirkt dabei bevorzugt wie die Klebeschicht 6 und verbindet die weitere Aufnahmeschicht 10 mit dem Werkstück 4. Mit der weiteren Aufnahmeschicht 10 ist weiterhin bevorzugt eine weitere Schicht 11 verbunden, die besonders bevorzugt als weiteres Werkstück 4 oder als weitere Stabilisierungsschicht ausgebildet sein kann.

Ferner ist denkbar, dass zwischen der weiteren Aufnahmeschicht 10 und der weiteren Schicht 11 eine weitere Klebeschicht vorgesehen ist. Ebenso ist vorstellbar, dass die Verbindungsschicht 8 nur optional vorhanden ist.

In Fig. 1d ist eine Stabilisierungsschicht 1 gezeigt, auf der eine Fassung 20 angeordnet ist. Die Fassung 20 erstreckt sich bevorzugt vollständig in Umfangsrichtung der Stabilisierungsschicht 1 und ist besonders bevorzugt mit der Stabilisierungsschicht 1 in Kontakt bringbar. Gemäß der Darstellung Fig. 1d ist der Innendurchmesser der Fassung 20 kleiner als der Außendurchmesser der Stabilisierungsschicht 1. Der durch die Fassung 20 und die Stabilisierungsschicht 1 begrenzte Innenraum dient zur Aufnahme von fließfähigem, insbesondere flüssigem, Material. Das Material erstarrt nach dem Zuführen in den Innenraum unter Ausbildung einer im Wesentlichen oder genau ebenen Schicht, insbesondere der Aufnahmeschicht 2.

Gemäß der Fig. 1e ist Fassung 20 größer als in der in Fig. 1d gezeigten Ausführungsform, wodurch die auf der Stabilisierungsschicht 1 erzeugte Aufnahmeschicht 2 bevorzugt im Wesentlichen und besonders bevorzugt vollständig die sich in der X-/Y-Ebene erstreckende Oberfläche der Stabilisierungsschicht 1 überlagert.

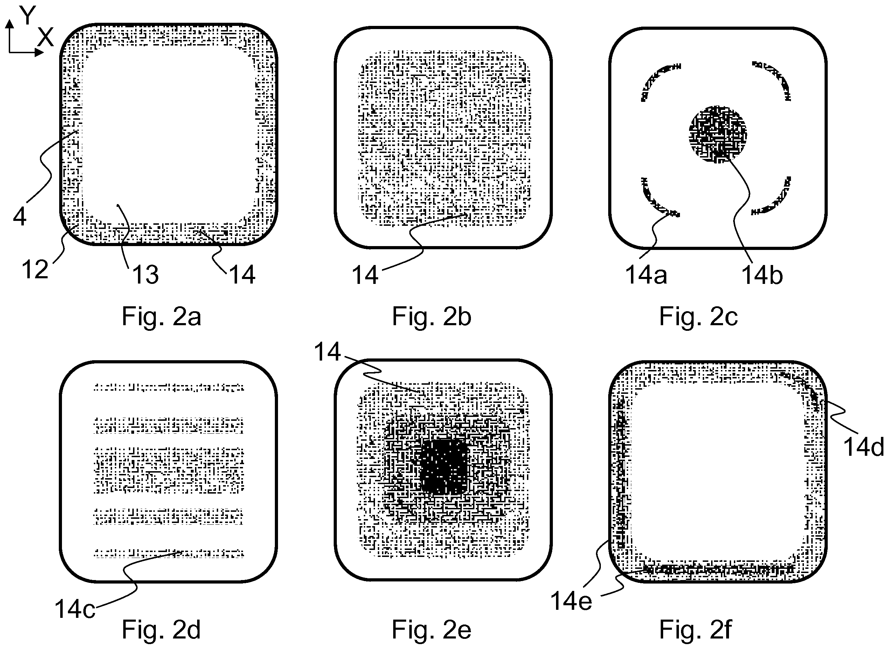

In den Figuren 2a-2f sind diverse definierte Spannungsfelder 14 dargestellt, wobei die gezeigten Spannungsfelder lediglich als Beispiele anzusehen sind, da beliebige weitere Kombinationen der gezeigten Spannungsfelder und/oder anders geformte Spannungsfelder vorgesehen werden können. Die dargestellte Werkstückgrundform kann zudem ebenfalls variieren, wobei die Werkstückgrundform (insbesondere in der X-/Y-Ebene) bevorzugt symmetrisch ist. Rein exemplarisch ist die Werkstückgrundform pseudoquadratisch dargestellt.

In Fig. 2a ist in einem Randbereich 12 des Werkstücks 4 eine durch die Schraffierung gekennzeichnete Spannungsverteilung 14 eingeleitet. Gemäß dem Gegenstand der vorliegenden Erfindung lässt sich aufgrund der lokal vorsehbaren definierten Spannungsverteilung/en 14 eine Rissausbreitung beim Abspalten einer Werkstoffschicht vom Werkstück 4 auf besonders vorteilhafte Weise beeinflussen bzw. kontrollieren.

Gemäß der Darstellung 2b ist die Spannungsverteilung invers zu der in Fig. 2a gezeigten Spannungsverteilung in das Werkstück 4 induziert. Es ist hierbei denkbar, dass die Spannung innerhalb eines definierten Spannungsbereichs 14 im Wesentlichen homogen ist.

Es ist jedoch ebenfalls denkbar, dass die Spannung innerhalb eines definierten Spannungsbereichs 14 stark variiert, insbesondere abschnittsweise ein Vielfaches der Spannung eines weiteren mit Spannungen beaufschlagten Bereichs aufweist.

In Fig. 2c ist eine Spannungsverteilung gezeigt, die mehrere ringförmige oder teilringförmige Anteile 14a und einen scheibenförmigen Anteil 14b aufweist. Es ist hierbei vorstellbar, dass zusätzlich oder alternativ zu einzelnen oder allen der gezeigten Anteile 14a, 14b sich flächig und/oder linienförmig, insbesondere geradlinig, erstreckende Anteile induzierbar sind.

In Fig. 2d sind sich zumindest abschnittsweise und bevorzugt vollständig geradlinig erstreckende Spannungsverteilungen 14c dargestellt. Die Anzahl der sich geradlinig erstreckenden Spannungsverteilungen 14c kann, wie dargestellt, genau 5 sein, wobei bevorzugt beliebig viele - auch unterschiedlich geformter Spannungsverteilungen -, insbesondere 1, 2, 3, 4, 5, 6, 7, 8, 9, 10 oder mehr unterschiedliche Spannungen, induziert werden können. Die einzelnen Spannungsverteilungen 14 können dabei in konstanten Abständen zueinander induzierbar sein, wobei sie besonders bevorzugt in beliebigen Abständen zueinander induzierbar sind. Bevorzugt nehmen die induzierten Spannungen 14c ausgehend vom Rand des Werkstücks 4 in Richtung Zentrum des Werkstücks 4 zu oder auch ab. Dies ist insbesondere dadurch dargestellt, dass die Flächen der einzelnen Spannungsfelder 14c ansteigen je näher sie zu dem Zentrum des Werkstücks 4 sind. Zusätzlich oder alternativ ist denkbar, dass die Spannungsfelder ähnliche oder gleiche Flächengrößen aufweisen, jedoch in der induzierten Spannungsintensität voneinander abweichen. Es ist ebenso vorstellbar, dass die Spannungen zum Zentrum hin abnehmen.

In Fig. 2e ist eine Spannungsverteilung dargestellt, deren Intensität von Werkstückrand in Richtung Werkstückzentrum in Stufen zunimmt. Es ist jedoch ebenfalls denkbar, dass die Spannungsintensität kontinuierlich zunimmt.

In Fig. 2f ist in den Randbereich 12 des Werkstücks 4 eine Grundspannung induziert. Weiterhin sind lokal definierte weitere Spannungsverteilungen 14d, 14e induziert. Analog zu den Figuren 2a und 2b kann die in Fig. 2f gezeigte Spannungsverteilung auch invers induziert werden.

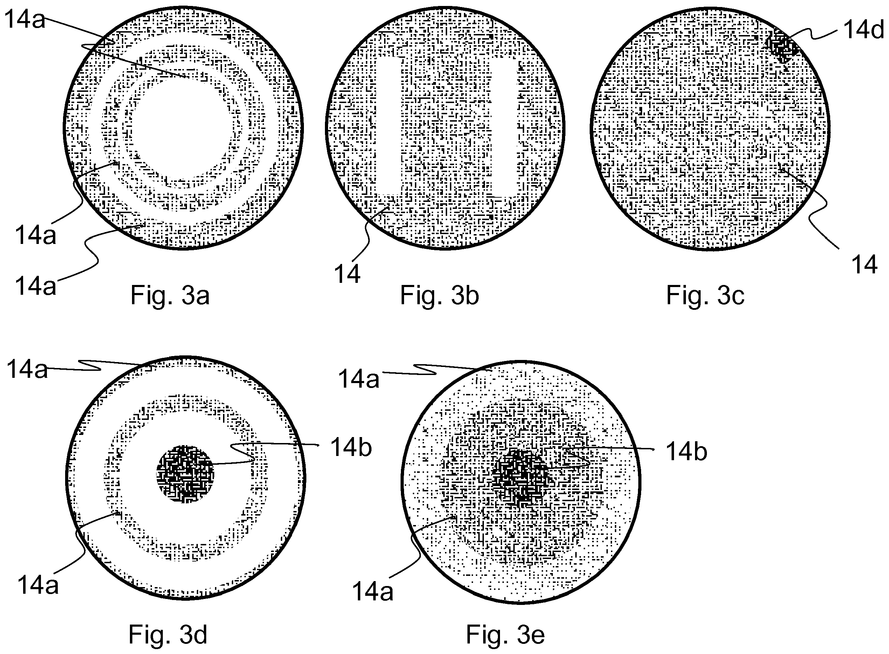

In den Figuren 3a-3e sind weitere lokal definierte Spannungsverteilungen im Werkstück 4 dargestellt. Die bezüglich der Fig. 2a-2f beschriebenen Merkmale und/oder Eigenschaften sind mit den nachfolgend beschriebenen Merkmalen und/oder Eigenschaften der in den Fig. 3a-3e gezeigten Spannungsverteilungen kombinierbar (dies gilt ebenso umgekehrt). Die Werkstückgrundform ist gemäß diesen Figuren rund dargestellt.

In Fig. 3a sind mehrere ringförmige Spannungsverteilungen 14a dargestellt. Es ist hierbei denkbar, dass die Spannungsverteilungen 14a nicht oder nur abschnittsweise ringförmig ausgebildet sind, bevorzugt kann auch abschnittsweise oder vollständig eine spiralförmige Spannungsverteilung induziert werden.

In Fig. 3b ist eine im Wesentlichen flächige bzw. scheibenförmige Spannungsverteilung 14b induziert, wobei die Spannungen im Bereich zweier definierter Abschnitte weniger stark induziert werden. Es ist hierbei denkbar, dass die Spannungen in nur einem Abschnitt weniger stark induziert werden. Weiterhin ist denkbar, dass die Spannungen in einer Vielzahl an Abschnitten weniger stark induziert werden. Die Abschnitte können dabei, wie dargestellt, sich länglich, insbesondere geradlinig, erstrecken oder eine davon abweichende, insbesondere sphärische, Form aufweisen.

In Fig. 3c ist wiederum eine erste Spannungsverteilung 14 und eine weitere Spannungsverteilung 14d induziert. Die weitere Spannungsverteilung 14d ist bevorzugt abschnittsweise ringförmig ausgebildet und erstreckt sich besonders bevorzugt entlang der Außenkante des Werkstücks. Vorzugsweise überlagern die Spannungen 14d, die Spannungen 14 oder vice versa.

In Fig. 3d ist die ringförmige Spannungsverteilung stellenweise weniger stark induziert.

Die Spannungen können bevorzugt je nach Anwendungsgebiet und besonders bevorzugt bei allen Werkstücken am Rand des Werkstücks, in der Mitte des Werkstücks und/oder in einem Bereich zwischen dem Rand bzw. einer Außenkante des Werkstücks und der Mitte bzw. dem Zentrum des Werkstücks induziert werden.

Bevorzugt nimmt die induzierte Spannung ausgehend vom Zentrum des Werkstücks 4 in Richtung Außenkante des Werkstücks 4 ab. Dies ist hierbei durch schmalere Spannungsfelder dargestellt.

In Fig. 3e ist eine Spannungsverteilung dargestellt, deren Intensität von Werkstückrand in Richtung Werkstückzentrum in Stufen zunimmt. Es ist jedoch ebenfalls denkbar, dass die Spannungsintensität kontinuierlich zunimmt, oder dass die Spannungsintensität in Richtung Werkstückzentrum in Stufen oder kontinuierlich abnimmt.

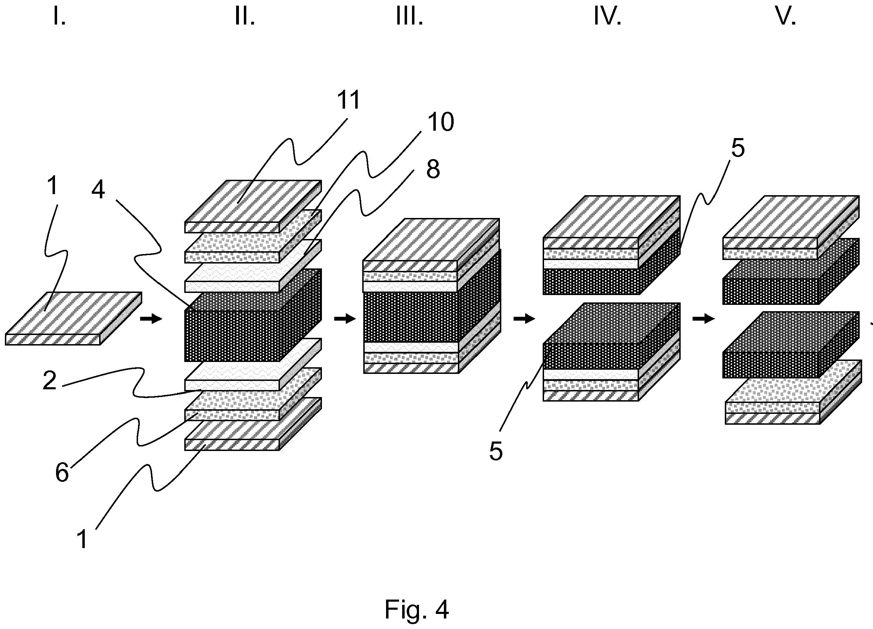

In Fig. 4 ist schematisch die Erzeugung einzelner Festkörperschichten aus einem Werkstück in Form einzelner Siliziumwafer gezeigt, welche unter Einbeziehung einer vordefinierten Spannungsverteilung derart abgespalten werden, dass sich eine gleichmäßige Dickenverteilung des abgespaltenen Wafers ergibt. Die vordefinierte Spannungsverteilung ist bevorzugt direkt oder indirekt, insbesondere mittels Strahlungsquellen, induzierbar. Als Strahlungsquellen können hierbei thermische Strahlungsquellen, wie Heizeinrichtungen oder Kühleinrichtungen, oder sonstige Strahlungseinrichtungen verstanden werden. Es ist ebenfalls denkbar, dass die Spannungsverteilungen durch Wärmeleitung oder Konvektion in das Werkstück induziert werden. Wärmestrahlung, Wärmeleitung oder Konvektion kann bevorzugt durch einzelne oder alle Schichten der Schichtungen 1, 6, 2 oder 8, 10, 11 hindurch bewirkt werden. Zusätzlich oder alternativ ist jedoch auch denkbar, dass die vordefinierte Spannungsverteilung direkt oder indirekt über eine Kraft- bzw. Momentenaufbringung auf eine bzw. mehrere der Schichten 1, 6, 2 oder 8, 10, 11 in das Werkstück einleitbar ist, das heißt, dass die Spannungen besonders bevorzugt durch die Kraft- bzw. Momentenbeaufschlagung auf eine oder mehrere der Stabilisierungsschichten 1, 11 bewirkt wird.

Dabei erfolgt in einem ersten Schritt I die Bereitstellung einer ersten Schicht, insbesondere der Stabilisierungsschicht 1, welche aus Metall und insbesondere aus Aluminium aufgebaut ist. Weiterhin ist denkbar, dass weitere Schichten 2, 4 ebenfalls in diesem Schritt bereit gestellt werden.

In dem zweiten Schritt II werden weitere bisher noch nicht bereitgestellte Schichten erzeugt und/oder mit einander verbunden. Bevorzugt werden die einzelnen Schichten wie dargestellt angeordnet. D.h., dass auf die Stabilisierungsschicht 1 bevorzugt eine Klebeschicht 6 (beispielsweise aus PDMS) aufgebracht wird, um eine Aufnahmeschicht 2 aus PDMS mit der Stabilisierungsschicht 1 zu koppeln bzw. zu verbinden. Die Aufnahmeschicht 2 steht bevorzugt direkt mit einem Werkstück 4 in Kontakt, wobei ebenfalls denkbar ist, dass eine Opferschicht bzw. eine weitere Klebeschicht zwischen der Aufnahmeschicht 2 und dem Werkstück 4 vorsehbar ist.

Der zuvor beschriebene Aufbau mit den Schichten 1, 6, und 2 auf dem Werkstück 4 kann an der anderen Seite des Werkstücks 4 analog aufgebracht werden oder alternativ in veränderter Form aufgebracht werden, wie im Folgenden erläutert ist. Parallel zur Aufnahmeschicht 2 und bevorzugt ebenfalls mit dem Werkstück 4 kontaktierend ist eine Verbindungsschicht 8 insbesondere in Form eines Klebers vorgesehen. Die Verbindungsschicht 8 kann zum Verbinden einer weiteren Aufnahmeschicht 10 aus PDMS und/oder einer weiteren Schicht 11 mit dem Werkstück 4 ausgebildet sein. Die weitere Schicht 11 ist dabei bevorzugt ebenfalls als Stabilisierungsschicht aus Metall oder als ein weiteres Werkstück ausgebildet, wobei an dem weiteren Werkstück wiederum ein entsprechender Schichtaufbau aus den Schichten 1, 6, 2 oder den Schichten 8, 10, 11 vorgesehen sein kann. Die Stabilisierungsschichten 1 sind bevorzugt steif bzw. bestehen aus steifen Materialien und ermöglichen eine mechanische Kopplung mit einer weiteren Einrichtung zur Spannungsbeaufschlagung. Der E-Modul der Stabilisierungsschicht 1 bzw. der Stabilisierungsschichten 1, 11 ist daher höher als der E-Modul der Aufnahmeschichten 2, 10. Zusätzlich oder alternativ ermöglichen die Stabilisierungsschichten 1 eine definierte lokale thermische Beaufschlagung des Werkstücks.

In dem Schritt III werden alle Schichten miteinander verbunden bzw. sind miteinander verbunden.

Im Schritt IV ist das Werkstück 4 in zwei Teile aufgespalten dargestellt, wobei ein Teil davon mit der Schichtanordnung 1, 6, 2 verbunden ist und der andere Teil mit der Schichtanordnung 8, 10, 11 verbunden ist. Beim Übergang vom Schritt III zum Schritt IV werden Spannungen in dem Werkstück 4 erzeugt, durch die das Werkstück 4 in mehrere, insbesondere genau zwei Teile bzw. Festkörperschichten aufgespalten wird. Bevorzugt erfolgt durch die Aufbringung von Kräften auf steiferen Stabilisierungsschicht/en 1, 11 eine mechanische Spannungsinduzierung in den Schichtaufbau. Die Spannungsinduzierung erfolgt aufgrund der beschriebenen Schichtanordnung mit Schichten 1, 6, 2 oder 8, 10, 11 unterschiedlicher E-Modulen äußerst vorteilhaft, da die Schichten mit geringeren E-Modulen beschädigungsfrei am Werkstück 4 anliegen können und die Schichten 1, 11 mit höheren E-Modulen mit weiteren Einrichtungen zur Kraftbeaufschlagung koppelbar sind.

Im optionalen Schritt V werden die einzelnen Festkörperschichten, die aus dem Werkstück 4 gewonnen wurden, wieder von den weiteren Schichten gelöst.

Das erfindungsgemäße Verfahren kann dabei zusätzlich oder alternativ einen oder alle der folgenden Schritte aufweisen: Bereitstellen eines Werkstücks zum Ablösen der Festkörperschichten, wobei das Werkstück zumindest eine exponierte Oberfläche aufweist, Erzeugen und/oder Bereitstellen einer Trägereinheit zum Aufnehmen mindestens einer Festkörperschicht, wobei die Trägereinheit mehrschichtig aufgebaut wird, wobei die Trägereinheit eine Stabilisierungsschicht aufweist und die Stabilisierungsschicht zumindest abschnittsweise durch eine Aufnahmeschicht überlagert wird, wobei die Aufnahmeschicht zum Halten der Festkörperschicht ausgebildet wird, und wobei die Stabilisierungsschicht zumindest abschnittsweise derart ausgebildet wird, dass sie einen E-Modul aufweist, der größer ist als der E-Modul der Aufnahmeschicht, und ein Verbinden der Aufnahmeschicht mit der exponierten Oberfläche des Werkstücks unter Bildung einer Kompositstruktur bzw. eines Laminats, sowie Beaufschlagen der Kompositstruktur mit einem inneren und/oder äußeren Spannungsfeld in der Art, dass die Festkörperschicht entlang einer sich innerhalb des Werkstücks erstreckenden Ebene von dem Werkstück abgelöst wird.

Gemäß einer bevorzugten Ausführungsform der vorliegenden Erfindung bestehen die Aufnahmeschicht und die Stabilisierungsschicht aus unterschiedlichen Materialien, wobei die Aufnahmeschicht bevorzugt ein Polymer, insbesondere Polydimethylsiloxane (PDMS), aufweist und die Stabilisierungsschicht bevorzugt ein Metall, insbesondere Aluminium, umfasst.

Mit der vorliegenden Erfindung, d.h. insbesondere durch die Verwendung von Polymer-Metall-Laminaten als Schichtsysteme zur Erzeugung thermisch induzierter mechanischer Spannungsfelder, werden alle zuvor genannten Probleme und Einschränkungen behoben. Als Werkstück wird in den hier beschriebenen Anwendungsbeispielen vorzugsweise ein dickerer Wafer verwendet, von welchem dann unter Verwendung des beschriebenen Verfahrens ein oder mehrere, dünnere Wafer abgespaltet werden. Diese Ausführungsform ist vorteilhaft, da sie ermöglicht die Dickenschwankungen massiv zu reduzieren, indem statt der nach bisherigem Stand der Technik verwendeten reinen Polymerschichten Schichten aus geeignet konfigurierten Polymer-Metall-Laminaten eingesetzt werden. Diese Schichten bestehen z.B. aus abwechselnd einer Lage aus Polymer und einer Lage aus einem Metall, z.B. Aluminium, wobei die innerste, d.h., die der Waferoberfläche am nächsten liegende, mechanische Spannung erzeugende Schicht bevorzugt jeweils immer aus Polymer besteht. Mit den entsprechenden, im Folgenden beschriebenen erfindungsgemäßen Verfahren können Festkörperschichten, wie insbesondere Wafer, mit viel geringeren totalen Dickenschwankungen hergestellt werden (Wafer mit Dickenschwankungen < 40% der mittleren Waferdicke wurden so bereits experimentell verifiziert), wobei bzgl. räumlicher Dickenverteilung vorteilhaftere lineare Muster erzielt und insbesondere die Bereiche mit den größten Schwankungen eingestellt werden können, wie z.B. in die Nähe des Waferrandes gebracht werden können, wo sie weniger stören.

Bei Anwendungsbeispielen, wo die äußerste (d.h., die am weitesten von der Waferoberfläche entfernte) Schicht des Laminats bevorzugt aus Metall besteht, hat dies infolge der guten Wärmeleitfähigkeit von Metallen außerdem den Vorteil, dass über diese Schicht ein sehr guter thermischer Kontakt zum Laminat möglich ist, was eine effiziente, lokal gut kontrollierbare und reproduzierbare Kühlung des Laminats ermöglicht. Außerdem kann eine Metallschicht oder Metallplatte üblicherweise einfacher an einer Maschine befestigt werden als die verwendeten Polymerschichten, was die automatisierte (Weiter-) Verarbeitung der Wafer erleichtert. Zudem erlaubt eine solche Befestigung, dass mittels einer Maschine, z.B. während des Kühlprozesses, auch externe mechanische Kräfte kontrolliert auf den Verbund Laminat-Wafer ausgeübt werden können, womit der Abspaltprozess weiter beeinflusst werden kann. Insbesondere ist denkbar, dass die Dicke der hergestellten Wafer sowohl durch von außen ausgeübten Kräften wie auch durch die Steifigkeit (Elastizitätsmodul) der beteiligten Schichten beeinflusst werden kann, und alle diese Parameter sind bei der Verwendung der erfindungsgemäßen Laminate in großen Bereichen gut und weitgehend unabhängig voneinander kontrollierbar. Weiterhin ist es besonders vorteilhaft, dass die Spannungsverteilungen aufgrund der erfindungsgemäßen Laminatstruktur, das heißt der Verwendung zumindest einer Metallschicht, einer Polymerschicht und dem Werkstück, durch die ausgeübten Kräfte und/oder die Steifigkeit der beteiligten Schichten lokal definiert vorgebbar ist, wobei zusätzlich oder alternativ eine inhomogene Temperaturverteilung in dem Werkstück oder den Laminatschichten für die vordefinierte Spannungsverteilung sorgt.

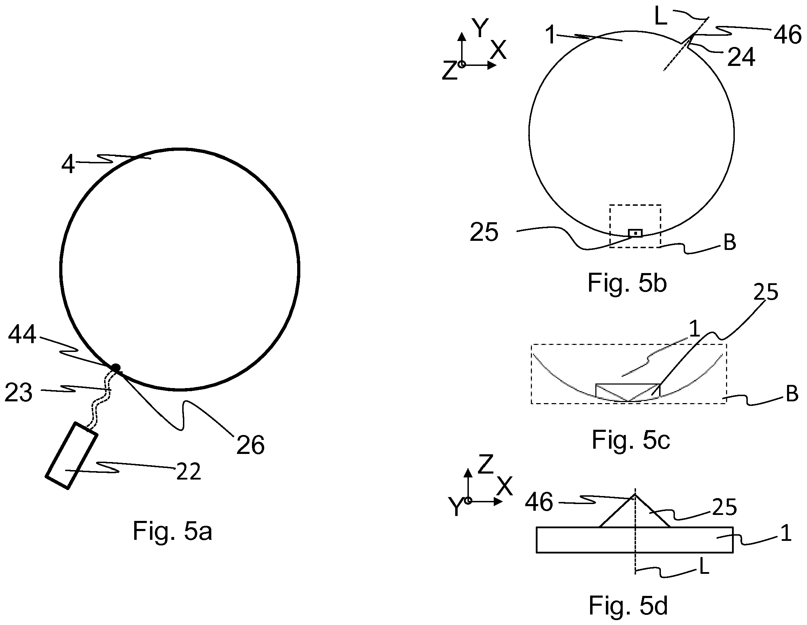

In Fig. 5a ist eine schematische Darstellung eines Werkstücks 4 dargestellt. Im dem Werkstück 4 werden mittels einer Impulsaussendeeinrichtung 22 Impulse 23, insbesondere in Form von Wellen, ausgesendet. Die Impulse 23 bewirken lokale Spannungen 26 im Randbereich des Werkstücks 4 und an einem Ort, an dem bevorzugt eine Bruchauslösung zum Abtrennen einer Festkörperschicht von dem Werkstück 4 erfolgt. Die lokalen Spannungen 26 treffen daher besonders bevorzugt an der Stelle auf den Randbereich des Werkstücks 4 bzw. auf dessen Umfang, an der die Bruchauslösestelle 44 gewünscht bzw. vorgesehen ist.

In Fig. 5b sind zwei Beispiele für Spannungsinduzierungsmittel 24, 25 dargestellt. Beide Spannungsinduzierungsmittel 24, 25 sind gemäß dieser Darstellung als Vorsprünge bzw. Erhebungen ausgebildet. Das Spannungsinduzierungsmittel 24 erstreckt sich über den Umfang einer bevorzugt gleichförmig die Stabilisierungsschicht 1 begrenzenden Außenkontur hinweg. Bevorzugt ist die mit einer Aufnahmeschicht 2 in Kontakt bringbare Oberfläche des Spannungsinduzierungsmittels 24 eben ausgebildet und erstreckt sich besonders bevorzugt in derselben Ebene, wie der verbleibende Oberflächenanteil der Stabilisierungsschicht 1. Das Spannungsinduzierungsmittel 24 weist bevorzugt ein Ende 46 auf, das spitz zuläuft. Die Spitze 46 kann dabei bevorzugt punktartig oder linienartig ausgebildet sein. Die gestrichelte und mit dem Buchstaben L gekennzeichnete Linie gibt bevorzugt die Erstreckungsrichtung an, in der sich das Spannungsinduzierungsmittel 24 mit seiner Längsachse erstreckt. Es lässt sich dieser Darstellung entnehmen, dass sich die Längsachse L des Spannungsinduzierungsmittels 24 in der X/Y-Ebene erstreckt.

Das zweite in Fig. 5b schematisch dargestellte Spannungsinduzierungsmittel 25 ist auf der Oberfläche der Stabilisierungsschicht 1 ausgebildet, mit der die Stabilisierungsschicht 1 mit der Aufnahmeschicht 2 verbunden wird.

Somit besteht ein Ausführungsbeispiel der Erfindung darin, lokal kontrollierte Spannungsspitzen in der Schichtstruktur durch gezielte Wahl der Schichtgeometrie zu erzeugen. Beispielsweise führen scharfe Ecken und Kanten in der Polymerschicht 2 zu lokalen mechanischen Spannungsspitzen während abgerundete Ränder diese reduzieren. Beispielsweise kann ein lokaler Sprung in der Dicke einer der Schichten 1, 2 im Schichtsystem zu einer lokalen Spannungsspitze führen.

Das Bezugszeichen B benennt einen gestrichelt dargestellten Bereich, in dem das weitere Spannungsinduzierungsmittel 25 angeordnet ist und der in Fig. 5c vergrößert dargestellt ist.

Es ist der Fig. 5c zu entnehmen, dass das Spannungsinduzierungsmittel 25 genau am Rand der Stabilisierungsschicht 1 angeordnet ist. Es ist jedoch ebenfalls denkbar, dass das Spannungsinduzierungsmittel 25 radial beabstandet zu dem umlaufenden Rand der Stabilisierungsschicht 1 angeordnet ist oder sich über den umlaufenden Rand hinaus erstreckt.

In Fig. 5d ist gezeigt, dass sich das Spannungsinduzierungsmittel 25 zu einem Ende hin verjüngt bzw. spitz zuläuft. Weiterhin lässt sich dieser Darstellung entnehmen, dass sich die Längsachse L des Spannungsinduzierungsmittels 25 in Z-Richtung erstreckt.

Die Spannungsinduzierungsmittel 24 und 25 können einzeln oder kombiniert vorgesehen sein. Es ist daher denkbar, dass zwei Spannungsinduzierungsmittel, insbesondere zwei verschiedenartige Spannungsinduzierungsmittel 24, 25, in unmittelbarer Nachbarschaft zueinander oder maximalweit voneinander beabstandet an einer Schicht 1, 2 oder an beiden Schichten 1, 2 angeordnet sind.

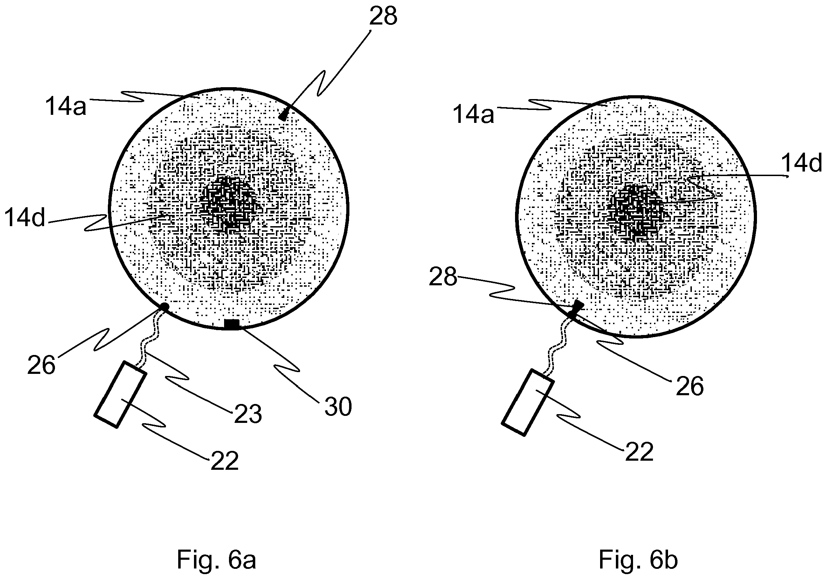

In Fig. 6a sind verschiedene Spannungen bzw. Spannungsverteilungen dargestellt. Zum einen ist eine Spannungszunahme vom Werkstückrand hin zum Werkstückzentrum durch dunkler werdende Flächenanteile 14a, 14d gekennzeichnet und zum anderen werden durch die schwarzen Felder 26, 28, 30 im Randbereich lokal induzierte Spannungen angezeigt. Hinsichtlich der vom Werkstückrand in Richtung Werkstückzentrum zunehmenden Spannungen wird insbesondere auf die Ausführungen zu den Figuren 2a-3e verwiesen. Die lokal induzierten Spannungen 26 werden durch die Beaufschlagung des Werkstücks 4 mittels Impulsen 23 erzeugt, die durch eine Impulsaussendeeinrichtung 22 ausgesendet werden. Die Spannungen 28 und 30 werden durch an einer nicht gezeigten Stabilisierungsschicht 1, insbesondere gemäß Fig. 5b, angeordneten Spannungsinduzierungsmittel 24, 25 erzeugt. Es ist hierbei jedoch ebenfalls denkbar, dass nur eines der lokal definierten Spannungsfelder 26, 28, 30 erzeugt wird oder dass beliebige Kombinationen dieser Spannungen bzw. Spannungsfelder 26, 28, 30 am Rand des Werkstücks 4 erzeugt werden.

Fig. 6b lässt sich unmittelbar entnehmen, dass die durch verschiedene Spannungsinduzierungseinrichtungen 24, 25 eingeleiteten lokal definierten Spannungen teilweise, vollständig oder ausschließlich in denselben Bereich 26, 28 des Wafers eingeleitet werden können. Die in denselben Bereich 26, 28 eingeleiteten Spannungen können sich teilweise oder vollständig überlagern und/oder können zeitlich teilweise oder vollständig versetzt in das Werkstück 4 eingeleitet werden.

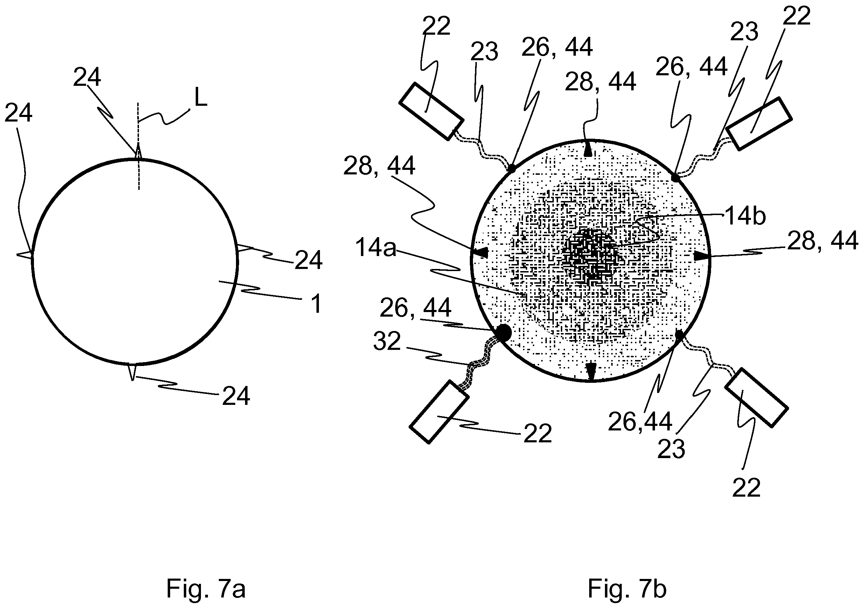

In Fig. 7a ist eine weitere schematische Darstellung einer rein beispielhaften Stabilisierungsschicht 1 gezeigt. Die Stabilisierungsschicht 1 weist eine Vielzahl bevorzugt im selben Abstand zueinander in Umfangsrichtung der Stabilisierungsschicht 1 angeordnete Spannungsinduzierungseinrichtungen 24 auf. Es ist denkbar, dass die Stabilisierungseinrichtung 1 genau oder mindestens 1, 2, 3, 4, 5, 6, 7, 8, 9 oder 10 gleichartige oder verschiedenartige Spannungsinduziereinrichtungen 24 aufweist.

In Fig. 7b ist ein Beispiel mehrerer induzierter Spannungen 26, 28, die durch verschiedenartige Spannungsinduziereinrichtungen 22, 24 eingeleitet werden, gezeigt. Die Spannungen 28 werden bevorzugt durch die Spannungsinduzierungsmittel 24 der in Fig. 7a gezeigten Stabilisierungsschicht 1 erzeugt. Die Spannungen 26 werden bevorzugt durch die Impulse 23 erzeugt, die durch die Impulsaussendungseinrichtungen 22 erzeugt werden. Das Bezugszeichen 44 kennzeichnet die Bruchauslösestelle/n die bevorzugt im Bereich oder an der Stelle der definiert in den Randbereich bzw. den Rand des Werkstücks 4 eingebrachten Spannungen liegt/liegen. Die dargestellten Formen der lokalen Spannungen 26, 28 sind als rein beispielhaft zu verstehen und können somit von den gezeigten Formen abweichen. Es ist zudem denkbar, dass die lokal definierten Spannungen im Wesentlichen punktförmig, linienförmig, flächig oder volumenförmig erzeugt werden.

Weiterhin ist in Fig. 7b rein beispielhaft gezeigt, dass die von den Impulsaussendeeinrichtungen 22 ausgesendeten Impulse 23, 32 bzw. die durch die Impulse 23, 32 bewirkten Spannungen 26, 28 verschieden sein können. Es ist hierbei denkbar, dass die ausgesendeten Impulse 23, 32 durch unterschiedliche Intensitäten, Wellenlängen etc. gekennzeichnet sein können. Vorstellbar ist ebenso, dass die durch die Spannungsinduzierungsmittel 24, 25 erzeugten Spannungen 28 im Werkstück 4 verschiedenstarke Ausprägungen, insbesondere Intensitäten, aufweisen können.

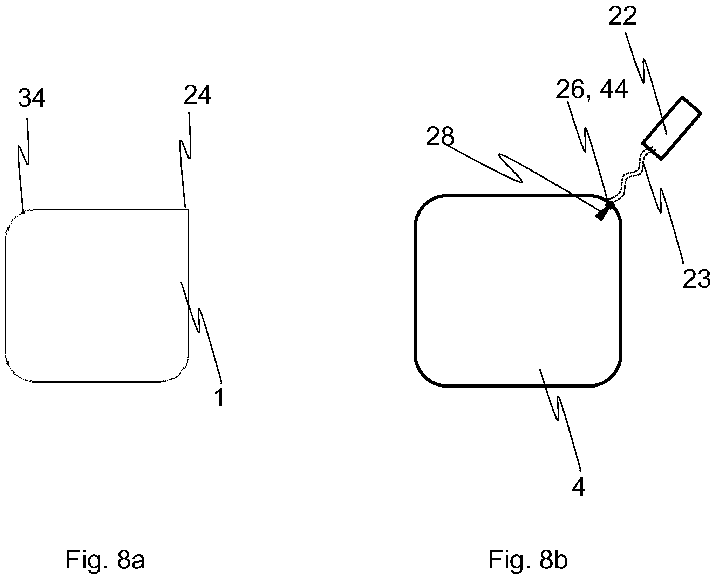

In Fig. 8a ist eine weitere beispielhafte Grundform einer Stabilisierungsschicht 1 gezeigt. Die Stabilisierungsschicht 1 ist im Wesentlichen rechteckig, insbesondere quadratisch, wobei im dargestellten Fall drei Ecken 34 abgerundet ausgebildet sind und eine Ecke spitz zuläuft. Die spitz zulaufende Ecke kann dabei als Spannungsinduziermittel 24 angesehen werden. Es erschließt sich aus dieser Darstellung ebenfalls, dass die Radien der abgerundeten Ecken 34 um ein Vielfaches größer sind als der Radius der nicht abgerundeten Ecke 24. Zusätzlich oder alternativ ist denkbar, dass ein oder mehrere Spannungsinduzierungsmittel 24, 25 im Bereich der sich länglich, insbesondere geradlinig, erstreckenden Körperkante der Stabilisierungsschicht 1 ausgebildet bzw. vorgesehen sein kann/können. Die hinsichtlich der in den Figuren 5a bis 7b gezeigten und bevorzugt im Wesentlichen rund ausgebildeten Stabilisierungsschichten 1 beschriebenen Ausgestaltungen sind besonders bevorzugt analog auf die in Fig. 8a gezeigte Ausgestaltungsform anwendbar und vice versa.

In Fig. 8b ist eine zur Fig. 6b im Wesentlichen analoge Ausgestaltungsform gezeigt. In das Werkstück 4 sind, z.B. durch die in Fig. 8a gezeigte Stabilisierungsschicht 1, die Spannungen 28 induziert. Zusätzlich oder alternativ dazu werden mittels der Impulsaussendeeinrichtung 22 weitere Spannungen 26 in das Werkstück, insbesondere an derselben Stelle, induziert. Die Stelle, an der die Spannungen 26 und/oder 28 induziert werden, ist besonders bevorzugt eine vordefinierte Bruchauslösestelle 44.

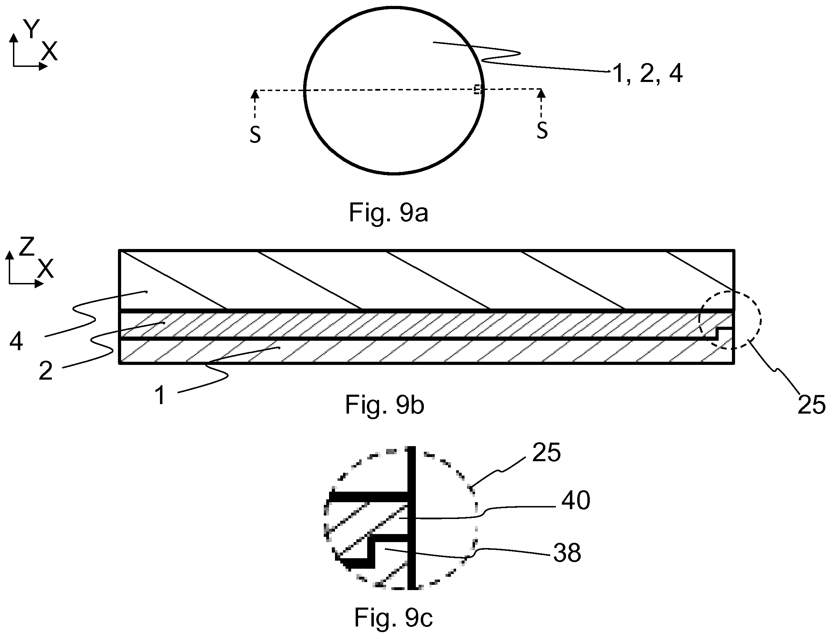

In Fig. 9a ist schematisch eine mehrschichtige Anordnung gezeigt. Die mehrschichtige Anordnung umfasst bevorzugt eine Stabilisierungsschicht 1, eine Aufnahmeschicht 2 und das Werkstück 4.

Weiterhin ist ein Schnitt S dargestellt, wobei die sich durch den Schnitt S ergebenden Schnittflächen in der Fig. 9b gezeigt sind. In der Fig. 9b ist ein gestrichelter Kreis gezeigt, der ein Spannungsinduzierungsmittel 25 zeigt. Das Spannungsinduzierungsmittel 25 ist gemäß dieser Ausführungsform durch das Zusammenwirken eines an der Stabilisierungsschicht 1 bzw. Metallplatte ausgebildeten Vorsprungs 38 mit einem in der Aufnahmeschicht 2 bzw. Polymerschicht ausgebildeten reduzierten Dickenanteil 40 ausgebildet. Es ist hierbei jedoch ebenfalls denkbar, dass der reduzierte Dickenanteil 40 in Form einer Ausnehmung 40 in der Stabilisierungsschicht 1 ausgebildet ist und der Vorsprung 38 in der Aufnahmeschicht 2 ausgebildet ist. Diese Ausgestaltung kann z.B. bewirken, dass die im Werkstück 4 induzierten Spannungen im Bereich des Vorsprungs 38 bzw. des reduzierten Dickenanteils 40 eine lokale Spannungsspitze aufweisen. Ausserdem kann diese Ausgestaltung z.B. bewirken, dass mittels der Stabilisierungsschicht 1 auf die Aufnahmeschicht 2 übertragene Kälte/Wärme im Bereich des Vorsprungs 38 bzw. des reduzierten Dickenanteils 40 schneller und/oder mit einer größeren Intensität auf die Aufnahmeschicht 2 einwirkt. Aufgrund des reduzierten Dickenanteils 40 ist die durch die Aufnahmeschicht 2 bewirkte Isolationswirkung bevorzugt lokal reduzierbar, einstellbar.

Ferner lässt sich dieser Darstellung lediglich ein bzw. genau ein Spannungsinduzierungsmittel 25 entnehmen. Es ist jedoch denkbar, dass weitere ähnliche oder verschiedenartige Spannungsinduziermittel 24, 25 vorgesehen sein können.

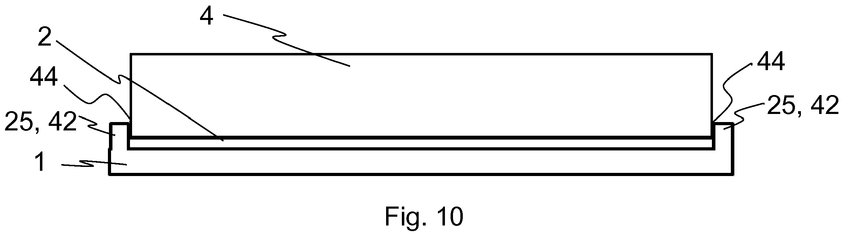

In Fig. 10 ist eine weitere Ausführungsform der vorliegenden Erfindung schematisch dargestellt. Gemäß dieser Ausführungsform erstrecken sich an der Stabilisierungsschicht 1 ausgebildete Spannungsinduzierungsmittel 25 in Form von zumindest zwei bzw. einer Vielzahl von Spannungsinduzierungsvorsprüngen 42 zumindest abschnittsweise über den äußeren Umfang des Werkstücks 4. Es ist hierbei denkbar, dass neben den beiden gezeigten Spannungsinduzierungsvorsprüngen 42 weitere, insbesondere 3, 4, 5, 6, 7, 8, 9, 10, Spannungsinduzierungsvorsprünge 42 oder nur ein bzw. genau ein Spannungsinduzierungsvorsprung 42 vorgesehen ist. Alternativ ist vorstellbar, dass ein Spannungsinduzierungsvorsprung 42 in Form eines umlaufenden Rings bzw. Kragens ausgebildet ist. Zusätzlich oder alternativ ist denkbar, dass die Aufnahmeschicht 2 bzw. die Polymerschicht derart gestaltet ist, dass sie Spannungsinduzierungsvorsprünge (analog zu den zuvor beschriebenen) ausbildet.

Die Spannungsinduzierungsvorsprünge 42 sind bevorzugt so gestaltet und positioniert, dass sie zur Induzierung von definierten lokalen Spannungen an Stellen, insbesondere Oberflächenanteilen im Randbereich des Werkstücks 4 bzw. genau am Rand des Werkstücks 4, dienen können, an denen eine Bruchauslösung bewirkt werden soll.

Weiterhin ist denkbar, dass die Vorsprünge 42 als umlaufend ausgebildeter Kragen ausgebildet sind. Der daraus resultierende pfannenartige Aufnahmebereich kann analog zu der in Fig. 1d bzw. 1e beschriebenen Ausführungsform verwendet bzw. eingesetzt werden. D.h., dass die Aufnahmeschicht 2 dadurch entstehen kann, dass flüssiges Polymer, insbesondere PDMS, eingegossen wird und vor dem vollständigen Aushärten als Kleber verwendet wird, um an dem Werkstück angebracht zu werden. Beim Abkühlvorgang kann dabei der umlaufende Kragen bzw. insbesondere eine Randlinie des Kragens, welche an dem Werkstück anliegt eine umlaufende Bruchauslöseebene in Form einer Vielzahl an Bruchauslösestellen vorgeben.

Die Spannungsinduzierungsvorsprünge 42 oder der umlaufende Kragen bestehen bevorzugt aus demselben Material, aus dem die Stabilisierungsschicht 1 besteht, bzw. sind bevorzugt ein einstückig damit verbundener Bestandteil. Die Stabilisierungsschicht 1 besteht zumindest in dem dargestellten Ausführungsbeispiel besonders bevorzugt aus Metall, insbesondere aus Aluminium. Über eine Temperierung der Metallplatte 1 und der dadurch erfolgenden Temperierung der Spannungsinduzierungsvorsprünge 24 bzw. des Kragens ist der Waferrandbereich lokal, insbesondere im Wesentlichen punktuell oder linienförmig, temperierbar, insbesondere abkühlbar.

In Fig. 11a ist eine weitere Ausführungsform dargestellt, gemäß der ein Spannungsinduzierungsmittel 27 als Ausnehmung 40 in der Aufnahmeschicht 2 bzw. der Polymerschicht ausgebildet ist. Die Ausnehmung 40 ist bevorzugt genau am Rand der Aufnahmeschicht 2 vorgesehen. Ferner ist in dieser Figur eine Schockfrostereinrichtung 48 gezeigt. Mit der Schockfrostereinrichtung 48 sind die Aufnahmeschicht 2, insbesondere im Bereich des Spannungsinduzierungsmittels 27, und/oder das Werkstück 4, insbesondere im Randbereich, bevorzugt lokal schnellabkühlbar. Die Schockfrostereinrichtung 48 kann z.B. flüssigen Stickstoff bereitstellen, der auf den jeweiligen schockzufrostenden Bereich der Aufnahmeschicht 2 und/oder des Werkstücks 4, insbesondere dosiert, aufbringbar ist bzw. direkt aufgespritzt wird.

In Fig. 11b ist gezeigt, dass zusätzlich oder alternativ, insbesondere analog zur in Fig. 11a gezeigten Ausführungsform, ein Spannungsinduzierungsmittel 27 in Form einer Ausnehmung 40 in der Stabilisierungsschicht 1 vorgesehen werden kann.

Bei den in den Figuren 11a und 11b gezeigten Ausführungsformen ist denkbar, dass die Anzahl an Ausnehmungen 40 beliebig am Umfang entlang gewählt werden kann. Weiterhin ist die Form und/oder Position der Ausnehmung/en 40 bevorzugt beliebig wählbar.

Die vorliegende Erfindung bezieht sich somit auf ein Verfahren zur Herstellung von Festkörperschichten , insbesondere zur Verwendung als Wafer, wobei durch eine definiert erzeugte Bruchauslösestelle ein abgespaltener Wafer nahezu ohne Dickenschwankung entsteht.

### Bezugszeichenliste

- 1.: Stabilisierungsschicht
- 2.: Aufnahmeschicht
- 4.: Werkstück
- 5.: Festkörperschicht
- 6.: Klebeschicht
- 8.: Verbindungsschicht
- 10.: Weitere Aufnahmeschicht
- 11.: Weitere Schicht
- 12.: Randbereich
- 13.: Zentrum
- 14.: Definierte Spannungsverteilung
- 14a: ringförmige Spannungsverteilung
- 14b: scheibenförmige Spannungsverteilung
- 14c: linienförmige Spannungsverteilung
- 14d: überlagernde Spannungsverteilung
- 14e: streifenförmige Spannungsverteilung
- 14f: punktförmige Spannungsverteilung
- 20: Fassung
- 22: Impulsaussendeeinrichtung
- 23: Impulse
- 24: Spannungsinduzierungsmittel
- 25: Weiteres Spannungsinduzierungsmittel
- 26: Durch die Impulsaussendeeinrichtung induzierte Spannungen
- 27: Ausnehmung
- 28: Durch das Spannungsinduzierungsmittel induzierte Spannungen
- 30: Durch das weitere Spannungsinduzierungsmittel induzierte Spannungen
- 32: Verstärkte Impulse
- 34: Bereich mit großem Radius
- 38: Vorsprung
- 40: Reduzierter Dickenanteil
- 42: Spannungsinduziervorsprung
- 44: Bruchauslösestelle
- 46: Spitzes Ende
- 48: Schockfrostereinrichtung

- L: Längsachse des Spannungsinduzierungsmittels
- X: Breite
- Y: Länge
- Z: Dicke / Tiefe

## Patentansprüche

1. Verfahren zur Herstellung von Festkörperschichten (5), insbesondere zur Verwendung als Wafer, mit den folgenden Schritten:
Bereitstellen eines Werkstücks (4) zum Ablösen der Festkörperschichten (5),
wobei das Werkstück (4) zumindest eine exponierte Oberfläche aufweist,
Erzeugen und/oder Bereitstellen einer Trägereinheit zum Aufnehmen mindestens einer Festkörperschicht (5),
wobei die Trägereinheit eine Aufnahmeschicht (2) zum Halten der Festkörperschicht (5) aufweist,
Anbringung der Aufnahmeschicht (2) an der exponierten Oberfläche des Werkstücks (4) unter Bildung einer Kompositstruktur, wobei die Aufnahmeschicht ein Polymer aufweist, wobei beim Beaufschlagen der Kompositstruktur aus Aufnahmeschicht und Werkstück mit einem inneren und/oder äußeren Spannungsfeld mindestens ein Teil des Polymers durch mindestens einen Glasübergang geht
Erzeugen einer Bruchauslösestelle (44) durch eine vordefinierte lokale Spannungsinduzierung im Randbereich, insbesondere am Rand, des Werkstücks (4) und
Abspalten der Festkörperschicht (5) von dem Werkstück (4) ausgehend von der Bruchauslösestelle (44)

2. Verfahren nach Anspruch 1
**dadurch gekennzeichnet, dass**
die vordefinierte lokale Spannungsinduzierung mittels einer Beaufschlagung der Kompositstruktur mit lokal eingeleiteten Kräften, einer lokalen Temperierung, insbesondere Abkühlung oder Aufheizung, einer lokalen Beaufschlagung mit Wellen, insbesondere Schallwellen oder Lichtwellen, einer lokalen Beaufschlagung mit Feldern, insbesondere elektromagnetischen Feldern, einer lokalen Beaufschlagung mit Elektrizität, insbesondere unter Ausnutzung des inversen Piezoeffekts, und/oder einer lokalen Beaufschlagung mit Strahlung aus einer Strahlungsquelle bewirkt wird.

3. Verfahren nach Anspruch 2,
**dadurch gekennzeichnet, dass**
auf der Aufnahmeschicht (2) eine Stabilisierungsschicht (1) angeordnet ist, wodurch eine Kompositstruktur gebildet wird und die lokale Spannungsinduzierung durch mindestens ein in der Kompositstruktur ausgebildetes Spannungsinduzierungsmittel (24, 25, 27) bewirkt wird, welches eine Spannungsspitze in der abzuspaltenden Festkörperschicht (5) derart erzeugt, dass sich die Bruchauslösestelle (44) ausbildet.

4. Verfahren nach Anspruch 3,
**dadurch gekennzeichnet, dass**
das Spannungsinduzierungsmittel (24, 25, 27) ein an der Stabilisierungsschicht (1) ausgebildeter Vorsprung (24, 25), insbesondere mit einem spitzen Ende (46), oder eine darin ausgebildete Ausnehmung (27) ist.

5. Verfahren nach Anspruch 3 oder Anspruch 4,
**dadurch gekennzeichnet, dass**
das Spannungsinduzierungsmittel (24, 25, 27) sich mit seiner Längsachse (L) in der Längsrichtung (X) oder in der Tiefenrichtung (Z) der Stabilisierungsschicht (1) erstreckt.

6. Verfahren nach einem der Ansprüche 3 bis 5,
**dadurch gekennzeichnet, dass**
in Umfangsrichtung der Stabilisierungsschicht (1) mehrere Spannungsinduzierungsmittel (24, 25, 27) an der Stabilisierungsschicht (1) ausgebildet sind.

7. Verfahren nach einem der Ansprüche 2 bis 6,
**dadurch gekennzeichnet, dass**
das Spannungsinduzierungsmittel (24, 25, 27) ein an der Aufnahmeschicht (2) ausgebildeter Vorsprung (24, 25), insbesondere mit einem spitzen Ende (46), oder eine darin ausgebildete Ausnehmung (27) ist.

8. Verfahren nach einem der Ansprüche 2 bis 7,
**dadurch gekennzeichnet, dass**
die lokale Spannungsinduzierung mittels einer Impulsaussendeeinrichtung (22) bewirkt wird, wobei die Impulsaussendeeinrichtung (22) Wellen, insbesondere Schallwellen oder Lichtwellen, aussendet.

9. Verfahren nach Anspruch 8,
**dadurch gekennzeichnet, dass**
mehrere Impulsaussendeeinrichtungen (22) in Umfangsrichtung des Werkstücks (4) angeordnet sind und an mehreren in Umfangsrichtung des Werkstücks (4) vorgesehenen Stellen mittels der Impulsaussendeeinrichtungen (22) Spannungen induziert werden.

10. Verfahren nach einem der Ansprüche 2 bis 9,
**dadurch gekennzeichnet, dass**
die lokale Spannungsinduzierung mittels eines Spannungsinduzierungsmittels (24, 25, 27) und einer Impulsaussendeeinrichtung (22) bewirkt wird, wobei das Spannungsinduzierungsmittel (24, 25, 27) durch eine geometrische Ausgestaltung der Kompositstruktur gebildet wird und die Impulsaussendeeinrichtung (22) Wellen, insbesondere Lichtwellen oder Schallwellen, aussendet.

11. Verfahren nach Anspruch 10,
**dadurch gekennzeichnet, dass**
die lokale Spannungsinduzierung durch das Spannungsinduzierungsmittel (24, 25, 27) und die Impulsaussendeeinrichtung (22) zeitgleich bewirkt wird.

12. Verfahren nach einem der Ansprüche 10 oder 11,
**dadurch gekennzeichnet, dass**
die lokale Spannungsinduzierung durch das Spannungsinduzierungsmittel (24, 25, 27) zeitlich länger bewirkt wird als durch die Impulsaussendeeinrichtung (22), wobei die Impulsaussendeeinrichtung (22) insbesondere in Abhängigkeit der Spannungsinduzierungsmittel (24, 25, 27) gesteuert wird.

13. Verfahren nach einem der vorangegangenen Ansprüche,
**dadurch gekennzeichnet, dass**
eine vordefinierte Spannungsverteilung (14) innerhalb des Werkstücks (4) zum Beeinflussen, insbesondere zum definierten Vorgeben, eines Abspaltverlaufs beim Abspalten der Festkörperschicht (5) von dem Werkstück (4) induziert wird und
die Festkörperschicht (5) von dem Werkstück (4) entlang einer sich innerhalb des Werkstücks (4) erstreckenden Ebene gemäß dem durch die vordefinierte Spannungsverteilung (14) beeinflussten Abspaltverlauf abgespalten wird, wobei die vordefinierte Spannungsverteilung (14) eine Spannungsverteilung darstellt, gemäß der die Spannungsintensität innerhalb einer Ebene des Werkstücks (4) ausgehend vom Zentrum des Werkstücks (4) in Richtung der Randbereiche des Werkstücks (4) zumindest abschnittsweise verschieden ist, wobei die Spannungsintensität im Zentrum des Werkstücks (4) bevorzugt größer ist als in der Nähe der Randbereiche des Werkstücks (4).

14. Verfahren nach einem der vorangegangenen Ansprüche,
**dadurch gekennzeichnet, dass**
durch eine Temperierung der Aufnahmeschicht Grundspannungen in dem Werkstück erzeugt werden, wobei die Grundspannungen geringer sind als die zur Rissauslösung erforderlichen Spannungen und durch die vordefinierte lokale Spannungsinduzierung im Randbereich die lokale Spannungserhöhung bewirkt wird, durch welche der Bruch ausgelöst wird, wobei ein Zeitraum zwischen der Erzeugung der Grundspannungen und der lokalen Spannungsinduzierung definiert vorgegeben wird.

15. Vorrichtung zur Herstellung von Festkörperschichten, insbesondere Wafern, mindestens umfassend
eine Einrichtung zum Induzieren von definierten lokalen Spannungen in einen Randbereich eines Werkstücks (4) zum Erzeugen einer Bruchauslösestelle (44) in dem Werkstück (4) zum Abspalten einer Festkörperschicht (5) von dem Werkstück (4),
wobei die Einrichtung einen Grundkörper (1) aufweist, der eine im Wesentlichen ebene Oberfläche zum Aufnehmen der Festkörperschicht (5) aufweist und wobei ein Spannungsinduzierungsmittel (24, 25, 27) an dem Grundkörper (1) ausgebildet ist und sich mit seiner Längsachse (L) in der Längsrichtung (X) des Grundkörpers (1) oder in der Tiefenrichtung (Z) des Grundkörpers (1) erstreckt **dadurch gekennzeichnet, dass**
mehrere Impulsaussendeeinrichtungen (22) in Umfangsrichtung des Werkstücks (4) angeordnet sind, um an mehreren in Umfangsrichtung des Werkstücks (4) vorgesehenen Stellen mittels der Impulsaussendeeinrichtungen (22) Spannungen zu induzieren.

## Claims

1. A method for the production of layers of solid material (5), in particular for use as wafers, the method comprising:
providing a workpiece (4) for the separation of the layers of solid material (5),
the workpiece (4) having at least one exposed surface;
producing and/or providing a carrier unit for receiving at least one layer of solid material (5),
the carrier unit having a receiving layer (2) for holding the layer of solid material (5), attaching the receiving layer (2) to the exposed surface of the workpiece (4) to form a composite structure, wherein the receiving layer comprises a polymer, wherein when exposing the composite structure including the receiving layer and the workpiece to an inner and/or outer stress field at least one part of the polymer undergoes at least one glass transition,
producing a break initiation point (44) with use of pre-defined local stress induction in a peripheral region, in particular at an edge, of the workpiece (4), and
separating the layer of solid material (5) from the workpiece (4) starting from the break initiation point (44).

2. The method according to claim 1,
**characterized in that**
the pre-defined local stress induction is brought about by exposing the composite structure to locally introduced forces, by local temperature control, in particular cooling or heating, local exposure to waves, in particular sound waves or light waves, local exposure to fields, in particular electromagnetic fields, local exposure to electricity, in particular by using the inverse piezo-effect, and/or local exposure to radiation from a radiation source.

3. The method according to claim 2,
**characterized in that**
a stabilization layer (1) is disposed over the receiving layer (2), thereby forming the composite structure, and the pre-defined local stress induction is brought about by at least one stress inducing means (24, 25, 27) formed in the composite structure that generates a stress peak in the layer of solid material (5) to be separated such that the break initiation point (44) is formed.

4. The method according to claim 3,
**characterized in that**
the stress inducing means (24, 25, 27) is a projection (24, 25) formed on the stabilization layer (1), in particular with a pointed end (46), or a recess (27) formed in the latter.

5. The method according to one of the claims 3 or 4,
**characterized in that**
the stress inducing means (24, 25, 27) extends with its longitudinal axis (L) in the longitudinal direction (X) or in the depth direction (Z) of the stabilization layer (1).

6. The method according to one of the claims 3 to 5,
**characterized in that**
a plurality of the stress inducing means (24, 25, 27) are formed on the stabilization layer (1) in the circumferential direction of the stabilization layer (1).

7. The method according to one of the claims 2 to 6,
**characterized in that**
the stress inducing means (24, 25, 27) is a projection (24, 25) formed on the reception layer (2), in particular with a pointed end (46), or a recess (27) formed in the latter.

8. The method according to one of the claims 2 to 6,
**characterized in that**
the local stress induction is brought about with a pulse emitting device (22), the pulse emitting device (22) emitting waves, in particular sound waves or light waves.

9. The method according to claim 8,
**characterized in that**
a number of pulse emitting devices (22) are arranged in the circumferential direction of the workpiece (4) and stresses are induced with the pulse emitting devices (22) at a number of points provided in the circumferential direction of the workpiece (4).

10. The method according to claim one of the claims 2 to 9,
**characterized in that**
the local stress induction is brought about with a stress inducing means (24, 25, 27) and a pulse emitting device (22), the stress inducing means (24, 25, 27) being formed by a geometric configuration of the composite structure, and the pulse emitting device (22) emitting waves, in particular light waves or sound waves.

11. The method according to claim 10,
**characterized in that**
the local stress induction is brought about at the same time by the stress inducing means (24, 25, 27) and the pulse emitting device (22).

12. The method according to one of the claims 10 or 11,
**characterized in that**
the local stress induction is brought about by the stress inducing means (24, 25, 27) over a longer time than by the pulse emitting device (22), the pulse emitting device (22) being controlled in particular depending on the stress inducing means (24, 25, 27).

13. The method according to one of the previous claims,
**characterized in that**
a pre-defined stress distribution (14) within the workpiece (4) is induced in order to influence, in particular to specify, in a defined manner, a separation sequence when separating the layer of solid material (5) from the workpiece (4), and
the layer of solid material (5) is separated from the workpiece (4) along a plane extending within the workpiece (4) according to the separating sequence influenced by the pre-defined stress distribution (14), the pre-defined stress distribution (14) constituting a stress distribution according to which the stress intensity within a plane of the workpiece (4) from the center of the workpiece (4) towards the peripheral regions of the workpiece (4) differs at least in sections, the stress intensity in the center of the workpiece (4) being preferably greater than close to the peripheral regions of the workpiece (4).

14. The method according to one of the previous claims,
**characterized in that**
basic stresses in the workpiece are generated by tempering the receiving layer, the basic stresses being smaller than the stresses required for crack initiation and the local increase in stress by which the break is initiated is brought about by the pre-defined local stress induction in the peripheral region, a period of time between generating the basic stresses and the local stress induction being specified in a defined manner.

15. Apparatus for the production of layers of solid material, in particular wafers, the device comprising:
a device for inducing defined local stresses in a peripheral region of a workpiece (4) for producing a break initiation point (44) in the workpiece (4) for separating a layer of solid material (5) from the workpiece (4),
wherein the device comprises a base body (1) comprising an essentially plane surface for receiving the layer of solid material (5) and wherein a stress inducing means (24, 25, 27) is formed on the base body (1) and extends with its longitudinal axis (L) in the longitudinal direction (X) of the ground body (1) or in the depth direction (Z) of the ground body (1), **characterized in that**
a number of pulse emitting devices (22) are arranged in the circumferential direction of the workpiece (4) in order to induce stresses at a number of points provided in the circumferential direction of the workpiece (4) with the pulse emitting devices (22).

## Revendications

1. Procédé de production de couches de corps solide (5), en particulier destinées à être utilisées comme wafer, comprenant les étapes suivantes :
le fait de préparer une pièce de fabrication (4) destinée à détacher les couches de corps solide (5), la pièce de fabrication (4) comprenant au moins une surface exposée,
la fabrication et/ou le fait de préparer une unité support destinée à recevoir au moins une couche de corps solide (5),
l'unité support comprenant une couche de réception (2) destinée à retenir la couche de corps solide (5),
le fait d'attacher la couche de réception (2) à la surface exposée de la pièce de fabrication (4) de manière à former une structure composite, la couche de réception comprenant un polymère, selon lequel lors de l'application d'un champ de contraintes interne et/ou externe à la structure composite composée de la couche de réception et de la pièce de fabrication au moins une partie du polymère passe au moins par une transition vitreuse,
la création d'un point d'amorce de rupture (44) par l'induction prédéfinie et locale de contraintes dans une zone périphérique, en particulier au niveau d'un bord, de la pièce de fabrication (4) et
la séparation de la couche de corps solide (5) de la pièce de fabrication (4) à partir du point d'amorce de rupture (44).

2. Procédé selon la revendication 1,
**caractérisé en ce que**
l'induction prédéfinie et locale de contraintes est obtenue par une application de forces induites localement sur la structure composite, un contrôle local de la température, en particulier un refroidissement ou un réchauffement, une application locale d'ondes, en particulier d'ondes sonores ou d'ondes lumineuses, une application locale de champs, en particulier de champs électromagnétiques, une application locale d'électricité, en particulier en utilisant l'effet piézoélectrique inverse, et/ou une application locale d'un rayonnement venant d'une source de rayonnement.

3. Procédé selon la revendication 2,
**caractérisé en ce que**
une couche de stabilisation (1) est disposée sur la couche de réception (2), formant ainsi une structure composite, et l'induction locale de contraintes est obtenue via au moins un moyen d'induction de contraintes (24, 25, 27) formé dans la structure composite, lequel crée une pointe de contrainte dans la couche de corps solide (5) à séparer de manière à ce que le point d'amorce de rupture (44) se forme.

4. Procédé selon la revendication 3,
**caractérisé en ce que**
le moyen d'induction de contraintes (24, 25, 27) est un épaulement (24, 25), en particulier avec une extrémité pointue (46), formé sur la couche de stabilisation (1) ou un évidement (27) formé dans celle-ci.

5. Procédé selon l'une des revendication 3 ou 4,
**caractérisé en ce que**
le moyen d'induction de contraintes (24, 25, 27) s'étend avec son axe longitudinal (L) dans la direction longitudinale (X) ou dans la direction de profondeur (Z) de la couche de stabilisation (1).

6. Procédé selon l'une des revendication 3 à 5,
**caractérisé en ce que**
plusieurs moyens d'induction de contraintes (24, 25, 27) sont formés sur la couche de stabilisation (1) dans la direction circonférentielle de la couche de stabilisation (1).

7. Procédé selon l'une des revendication 2 à 6,
**caractérisé en ce que**
le moyen d'induction de contraintes (24, 25, 27) est un épaulement (24, 25), en particulier avec une extrémité pointue (46), formé sur la couche de réception (2) ou un évidement (27) formé dans celle-ci.

8. Procédé selon l'une des revendication 2 à 7,
**caractérisé en ce que**
l'induction locale de contraintes est obtenue au moyen d'un dispositif d'émission d'impulsions (22), le dispositif d'émission d'impulsions (22) émettant des ondes, en particulier des ondes sonores ou lumineuses.

9. Procédé selon la revendication 8,
**caractérisé en ce que**
plusieurs dispositifs d'émission d'impulsions (22) sont disposés dans la direction circonférentielle de la pièce de fabrication (4) et on induit des contraintes au niveau de plusieurs points prévus dans la direction circonférentielle de la pièce de fabrication (4) au moyen des dispositifs d'émission d'impulsions (22).

10. Procédé selon l'une des revendication 2 à 9,
**caractérisé en ce que**
l'induction locale de contraintes est obtenue au moyen du moyen d'induction de contraintes (24, 25, 27) et du dispositif d'émission d'impulsions (22), le moyen d'induction de contrainte (24, 25, 27) étant formé par une forme géométrique de la structure composite et le dispositif d'émission d'impulsions (22) émettant des ondes, en particulier des ondes sonores ou lumineuses.

11. Procédé selon la revendication 10,
**caractérisé en ce que**
l'induction locale de contraintes par le moyen d'induction de contraintes (24, 25, 27) et le dispositif d'émission d'impulsions (22) est obtenue simultanément.

12. Procédé selon l'une des revendication 10 ou 11,
**caractérisé en ce que**
l'induction locale de contraintes par le moyen d'induction de contraintes (24, 25, 27) est obtenue sur une période plus longue que par le dispositif d'émission d'impulsions (22), le dispositif d'émission d'impulsions (22) étant commandé en particulier en fonction du moyen d'induction de contraintes (24, 25, 27).

13. Procédé selon l'une des revendication précédentes,
**caractérisé en ce que**
on induit une distribution des contraintes (14) prédéfinie à l'intérieur de la pièce de fabrication (4) destinée à influer, en particulier à prédéterminer de manière définie, le déroulement de la séparation lors de la séparation de la couche de corps solide (5) de la pièce de fabrication (4) et
on sépare la couche de corps solide (5) de la pièce de fabrication (4) le long d'un plan qui s'étend à l'intérieur de la pièce de fabrication (4) selon le déroulement de la séparation influé par la distribution des contraintes (14) prédéfinie, la distribution des contraintes (14) prédéfinie représentant une distribution des contraintes (14) selon laquelle l'intensité des contraintes à l'intérieur d'un plan de la pièce à fabriquer (4) en partant du centre de la pièce à fabriquer (4) et en allant vers les zones périphériques de la pièce à fabriquer (4) est différente au moins par tronçons, l'intensité des contraintes au centre de la pièce à fabriquer (4) étant de préférence plus importante qu'à proximité des zones périphériques de la pièce à fabriquer (4).

14. Procédé selon l'une des revendication précédentes,
**caractérisé en ce que**
on crée des contraintes de base dans la pièce à fabriquer en contrôlant la température de la couche de réception, les contraintes de base étant plus faibles que les contraintes nécessaires pour amorcer une fissure, et on provoque l'augmentation locale des contraintes qui amorce la rupture avec l'induction locale et prédéfinie des contraintes dans la zone périphérique, selon lequel on prédétermine de manière définie une période de temps entre la création des contraintes de base et l'induction locale des contraintes.

15. Appareil de production de couches de corps solide, en particulier de wafers, comprenant au moins :
un dispositif destiné à induire des contraintes locales définies dans une zone périphérique de la pièce de fabrication (4) afin de créer un point d'amorce de rupture (44) dans la pièce à fabriquer (4) pour séparer une couche de corps solide (5) de la pièce à fabriquer (4),
le dispositif comprenant un corps de base (1) comprenant une surface essentiellement plane destinée à recevoir la couche de corps solide (5) et un moyen d'induction de contraintes (24, 25, 27) étant formé sur le corps de base (1) et s'étendant avec son axe longitudinal (L) dans la direction longitudinale (X) du corps de base (1) ou dans la direction de profondeur (Z) du corps de base (1), **caractérisé en ce que**
plusieurs dispositifs d'émission d'impulsions (22) sont disposés dans la direction circonférentielle de la pièce de fabrication (4) afin d'induire des contraintes au niveau de plusieurs points prévus dans la direction circonférentielle de la pièce de fabrication (4) au moyen des dispositifs d'émission d'impulsions (22).
